# EUROPEAN PATENT APPLICATION

(11) **EP 4 838 398 A1**
(43) Date of publication of application: **11.11.2026**
(21) Application number: 25305657.6
(22) Date of filing: 07.05.2025
(51) Int. Cl.: G06F 30/17, G06F 30/27, G06F 30/12

(54) **OPERATOR PREDICTION IN BLOCK REPRESENTATION WITH DATASET**

(71) Applicant: Dassault Systèmes, 78140 Vélizy-Villacoublay (FR)
(72) Inventor: FERREIRA, Isaque, Vélizy-Villacoublay (FR)
(74) Representative: Bandpay & Greuter

(57) **Abstract**

The disclosure notably relates to a computer-implemented method for designing a 3D modeled object representing a product to be manufactured. The designing method comprises, by a computer system, displaying simultaneously a 3D shape representation of the 3D modeled object, and a 2D block representation of the 3D modeled object. The designing method also comprises by a user interacting graphically with the 2D block representation, performing a selection, among the at least one block node, of one or more connectors. The designing method also comprises using a pre-trained machine-learning function and a dataset based on a plurality of previously performed designs for prediction of one or more operators among the predetermined set of operators. The disclosure improves ergonomics.

## Description

### TECHNICAL FIELD

The disclosure relates to the field of computer programs and systems, and more specifically to methods, devices and programs related to the prediction of one or more operators in a block representation of a product to be manufactured.

### BACKGROUND

A number of solutions, hardware and software, are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for analyzing and simulating the physical behavior of a future product. CAM is an acronym for Computer-Aided Manufacturing, e.g. it relates to software solutions for defining product manufacturing processes and resources. In such computer-aided design solutions, the graphical user interface plays an important role as regards the efficiency of the technique. These techniques may be embedded within Product Lifecycle Management (PLM) solutions. PLM refers to an engineering strategy that helps companies to share product data, apply common processes, and leverage corporate knowledge for the development of products from conception to the end of their life, across the concept of extended enterprise. The PLM solutions provided by Dassault Systèmes (under the trademarks CATIA, SIMULIA, DELMIA and ENOVIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the solutions deliver common models linking products, processes, resources to enable dynamic, knowledge-based product creation and decision support that drives optimized product definition, manufacturing preparation, production and service.

As part of the CATIA software suite, xGenerative Design is a known web application that allows designing a 3D modeled object representing a product to be manufactured, based on a 2D block representation of the 3D modeled object. In said application, a user may select an output connector of the 2D block representation, and then manually search, via dedicated menus, for a new operator to be added to the representation and to be connected to the selected output connector via respective arc(s). Such manual search involves text entering in a search bar and/or scrolling of a long and unordered list of operators.

Ergonomics of such a solution needs to be improved.

### SUMMARY

It is therefore provided a computer-implemented method for designing a 3D modeled object representing a product to be manufactured. The designing method comprises, by a computer system, displaying simultaneously a 3D shape representation of the 3D modeled object, and a 2D block representation of the 3D modeled object. The 2D block representation comprises block nodes, one or more input connectors and an output connector on each respective block node, arcs each between the output connector of a first block node and a respective input connector of a second block node.

Each block node represents a respective operator among a predetermined set of operators. Each operator of the predetermined set of operators has a respective data identifier. Each operator of the predetermined set of operators further has one or more inputs and an output. Each input of each operator has a respective data identifier. The output of each operator has a respective data identifier.

For at least one block node, the output of the respective operator represented by the at least one block node is a respective set of one or more geometrical objects. For said at least one block node, the output of the operator has a dynamic object cardinality, at least one input of the operator having a dynamic object cardinality. And for said at least one block node, the output of the operator has an object type, where optionally the object type of the output of the operator is dynamic, in which case at least one input of the respective operator has a dynamic object type.

Each input connector represents a respective input of the respective operator represented by the respective block node. The output connector represents the output of the respective operator represented by the respective block node.

Each arc represents data flow from the output connector of the first block node to the respective input connector of the second block node.

The 2D block representation is configured such that an execution of the data flow represented by the arcs of the 2D block representation outputs the 3D shape representation.

The designing method also comprises by a user interacting graphically with the 2D block representation, performing a selection, among the at least one block node, of one output connector. The block node of the selected output connector has an antecedent block node.

The designing method also comprises obtaining a pre-trained machine-learning function.

The designing method further comprises obtaining a dataset including pieces of data. The dataset is based on a plurality of previously performed designs. Each piece of data comprises a tuple and a weight. The tuple comprises a first operator represented by a first block node in a design of the plurality of previously performed designs. The tuple further comprises a second operator represented by a second block node in the design, the second block node having an output connector connected to the first block node. The tuple further comprises a third operator represented by a third block node having a respective input connector connected to a respective output connector of the first block node. The tuple further comprises the object type of the respective output connector of the first block node. The weight depends on an extent of instantiation of the tuple in the plurality of previously performed designs.

The designing method further comprises providing to the machine-learning function input data. The input data include at least the data identifier of the respective operator represented by the block node of the selected output connector, the data identifier of the selected output connector, and an object type of the selected output connector.

The designing method further comprises outputting, based on a result of the machine-learning function and on the dataset, a prediction of one or more operators among the predetermined set of operators.

The designing method further comprises:
- by the computer system, displaying a graphical representation of at least one operator of the prediction;
- by the user, selecting an operator among the at least one operator of the prediction;
- by the computer system,
   adding to the 2D block representation a block node representing the selected operator; and
   updating the display of the 2D block representation, at least by displaying the added block node;
   adding to the 2D block representation an arc between the selected output connector and a respective connector of the added block node, thereby obtaining an updated 2D block representation;
- updating the display of the 2D block representation, at least by displaying the added arc; and
- executing the data flow represented by the arcs of the updated 2D block representation, thereby outputting an updated 3D shape representation; and
- displaying the updated 3D shape representation.

Such a designing method forms an improved solution for designing a 3D modeled object representing a product to be manufactured, as it provides the ergonomics of a software application which displays a 2D block representation simultaneously to a 3D shape representation, with all the graphical user-interaction capabilities offered by this type of application, such as the ability for the user to graphically interact with the 2D block representation in order to select one or more of the displayed elements and make editions. In addition, by involving the pre-trained machine-learning function and the dataset based on the plurality of previously performed designs, the designing method allows selecting and adding an operator in an aided and thereby fast manner. Notably, the machine-learning function may suggest the most common operators and the dataset may complement such suggestion taking into account the frequency of use of the operators. The dataset may also depend on the user and provide suggestions tailored to the specific user. By then executing the data flow, the designing method allows for an ergonomic update of the displayed 3D shape representation, which is eventually to be fed potentially as such to a manufacturing process which may be automatic.

The designing method may comprise one or more of the following:
- the outputting, based on the machine-learning function and the dataset, of a prediction of one or more operators comprises:
   ∘ obtaining as a result of the machine-learning function a first score of each given operator of the predetermined set of operators;
   ∘ determining a second score of each given operator of the predetermined set of operators, the second score of the given operator representing a frequency of a respective tuple in the dataset for which:
      ▪ the first operator of the respective tuple is the respective operator represented by the block node of the selected output connector,
      ▪ the second operator of the respective tuple is the respective operator represented by the antecedent block node of the block node of the selected output connector,
      ▪ the third operator of the respective tuple is the given operator,
      ▪ the object type of the respective tuple is the object type of the selected output connector; and
   ∘ combining the first and second score, thereby obtaining a third score of each operator of the predetermined set of operators;
- the frequency of a respective tuple represented by the second score is a frequency of the respective tuple among all tuples of the dataset having the same first operator, second operator, and object type as the respective tuple;
- the second score Score₂(*Oᵢ*) of an operator *Oᵢ* is given by the formula: ${Score}_{2} \left({O}_{i}\right) = \frac{{w}_{i}}{{\sum }_{j} {w}_{j}}$ where {*Oⱼ*}*ⱼ* is a set of operators comprising the operator *Oᵢ* and comprised in the predetermined set of operators, each operator *Oⱼ* being the third operator of a tuple of which first operator, second operator, and object type are the same as those of the respective tuple of *Oᵢ*, and where *wⱼ* is a weight of the tuple having as third operator *Oⱼ*;
- the third score of each operator of the predetermined set of operator is a convex combination of the first and the second score of the operator;
- the third score Score₃ (*O*) of an operator *O* of the predetermined set of operators is given by the formula: ${Score}_{3} \left(O\right) = \frac{c ⋅ {Score}_{1} \left(O\right) + c ′ ⋅ {Score}_{2} \left(O\right)}{c + c ′}$ where:
   ∘ *c* and *c'* are numerical coefficients,
   ∘ Score₁(*O*) is the first score of the operator *O*, and
   ∘ Score₂ (*O*) is the second score of the operator *O*.
- the designing method further comprises, after the selecting, by the user, of an operator among the at least one operator of the prediction, increasing by a predetermined number the weight of a respective tuple of the dataset for which:
   o the first operator of the respective tuple is the respective operator represented by the block node of the selected output connector,
   o the second operator of the respective tuple is the respective operator represented by the antecedent block node of the block node of the selected output connector,
   o the third operator of the respective tuple is the selected operator, and
   o the object type of the respective tuple is the object type of the selected output connector;
- the input data of the machine-learning function further comprise a value depending on an object cardinality of the selected output connector;
- the value depending on the object cardinality of the selected output connector is a binary value indicative of whether the cardinality is 1 or higher than 1; and/or
- the machine-learning function is a multilayer perceptron.

It is further provided a computer program comprising instructions for performing the designing method. When executed by a processor, the instructions cause the processor to perform the designing method.

It is further provided a computer readable storage medium having recorded thereon the computer program.

It is further provided a system comprising a processor coupled to a memory and a graphical user interface, the memory having recorded thereon the computer program.

### BRIEF DESCRIPTION OF THE DRAWINGS

Non-limiting examples will now be described in reference to the accompanying drawings, where:
- FIG. 1 shows a flowchart of an example of the designing method;
- FIG. 2 shows an example of the device as a computer system;
- FIG.s 3-25 illustrate an implementation of the methods, programs and devices of the present disclosure.

### DETAILED DESCRIPTION

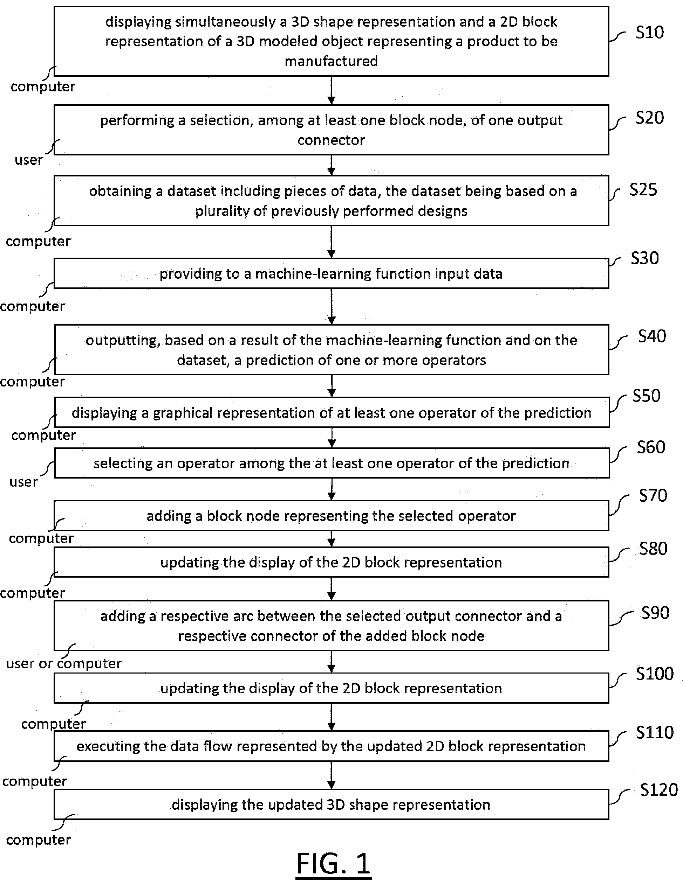

With reference to the flowchart of FIG. 1, it is proposed a computer-implemented method for designing a 3D modeled object representing a product to be manufactured (i.e., a product of manufacture, in other words a manufacturing product). The designing method of FIG. 1 involves a user interacting with a 2D block representation of the 3D modeled object displayed by a computer system (e.g., one or more screens of the computer system or of another computer system served by the computer system), in an improved manner from the point of view of ergonomics. The interaction is performed within a software application run locally on a computer system or within a web application served by a (e.g., distant/remote) computer system to a local workstation. When actions are indicated as being performed by "the" computer system in the present disclosure, and in particular on FIG. 1, it must be understood that these actions may in fact be at least partly performed and/or triggered by such software or web application.

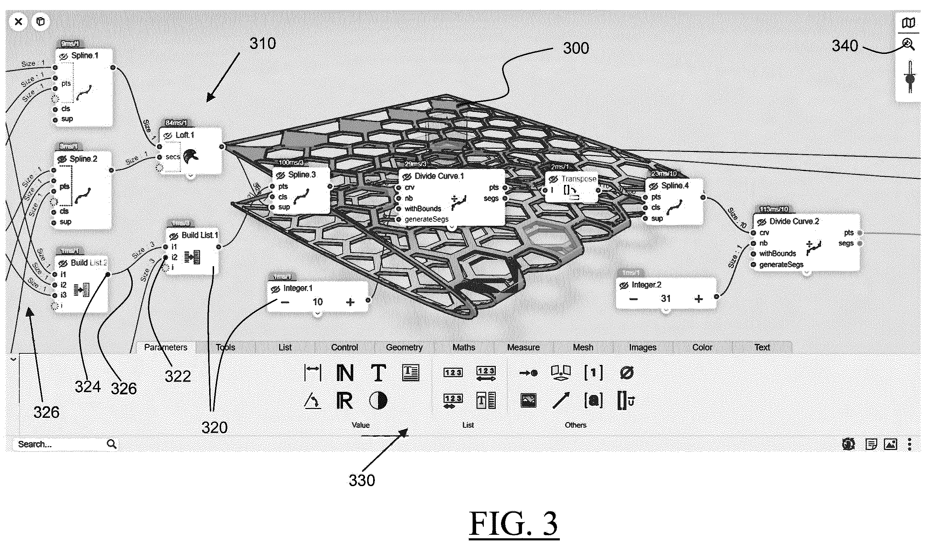

The designing method comprises, by the computer system, displaying S10 simultaneously a 3D shape representation of the 3D modeled object, and the 2D block representation of the 3D modeled object. This allows the user to interact with the 2D block representation while viewing the 3D shape representation at the same time. While the 2D block representation offers, as known, an ergonomic interface to define and edit parameters related to the shape of the product to be manufactured, the 3D shape representation allows the user to directly view the end result, thus having a sight of the exact shape that will be eventually manufactured. The designing method may at S10 display the 3D shape representation and the 2D block representation aside each other, for example in two separate windows or two separate scenes of a same window, displayed aside on a same screen or each on a respective one of two distinct screens. Alternatively, the designing method may at S10 display the 3D shape representation and the 2D block representation one superposed over the other, for example the 2D block representation superposed over (e.g., and in foreground of) the 3D shape representation (e.g., see FIG. 3). Although represented by a single box in the flowchart of FIG. 1, the simultaneous display of S10 may be performed throughout the remainder of the designing method, such that each user-interaction of the designing method resulting in an update of the 2D block representation and/or in an update of the 3D shape representation may yield an update in what the user sees on screen(s). The update of the display S10 may be performed automatically and/or in real-time (where the expression "real-time" may refer to a lag of at most 10 seconds or even 1 second, here and/or at any other use of this expression in the remainder of the disclosure), upon determination by the computer system of an update of the 2D block representation and/or an update of the 3D shape representation.

The 2D block representation displayed at S10 comprises block nodes, one or more input connectors and an output connector on each respective block node, and arcs each between the output connector of a first block node and a respective input connector of a second block node.

By "block node" it is meant any 2D graphism of a block shape, for example a rectangle or square shape, or alternatively any other polygonal shape, such as a trapezoid shape, a circle or oval shape, or any other type of block-like shape distinguishable as a block to the user. The 2D block representation may be displayed over a background, and the different block nodes may be physically separated on the display, e.g., with a non-zero gap between each pair of block nodes. A "block node" is a node of a virtual graph, wherein the virtual graph consists of blocks as its graph nodes/vertices, with a graph arc/edge between two graph nodes if there is at least one arc (in the 2D block representation) between the two corresponding block nodes. This virtual graph may be referred to as the "graph corresponding to the 2D block representation".

The one or more input connectors and the output connector of each respective block node may each be represented by a respective graphism displayed on the respective block node, for example by a respective symbol displayed over the respective block node. The respective block node may comprise a boundary line, and at least one (e.g., each) such respective graphism (e.g., symbol) may be displayed over said boundary line. Each such respective graphism (e.g., symbol) may be smaller than the respective block node, for example at least ten times smaller in terms of occupied area in the 2D block representation (i.e., area occupied on screen). Each such respective graphism (e.g., symbol) may be a small compact symbol, for example a dot, a bullet, or a square, or any other type of shape distinguishable from the block nodes to the user. The different connectors may be physically separated on the display, e.g., with a non-zero gap between each pair of connectors. The one or more input connectors of each respective block node may all have a visually identical or identically-shaped respective graphism, and said respective graphism may optionally be visually identical or identically-shaped to the respective graphism of the output connector(s) of the respective block node. Optionally, the one or more input connectors of all block nodes may all have a visually identical or identically-shaped respective graphism, and said respective graphism may further optionally be visually identical or identically-shaped to the respective graphism of the output connector(s) of all block nodes. All connectors may for example be represented by the same dot symbol. Optionally, all block nodes may be oriented in a same manner in the 2D block representation, and all input connectors in the 2D block representation may be arranged on a same side of their respective block nodes, for example on a left side of their respective block nodes, and/or all output connectors in the block representation may be arranged on a same side of their respective block nodes, for example on a right side of their respective block nodes. For example, all block nodes may be represented each by a respective rectangle (or rectangular shape), and each rectangle may be oriented with its sides parallel to the screen's sides. All input connectors of each block node may be represented by an identical or identically-shaped dot shape/symbol and all on the left side of the rectangle, and all output connectors may be represented by an identical or identically-shaped dot shape/symbol (e.g., same dot shape/symbol as for the input connectors) and all on the right side of their respective block node's rectangle (e.g. see FIG. 3).

Each arc may be represented by a respective line linking the graphism/symbol (e.g., dot shape) of the output connector of the first block node and the graphism/symbol (e.g., dot shape) of the respective input connector of the second block node.

The block nodes, connectors and arcs may each be user-selectable, for example by the user interacting graphically with the 2D block representation, and in particular by the user interacting graphically specifically with the element to be selected, for example using a haptic device such as a mouse or a touch pad or a touch screen. The system may be configured for a user to be able to perform such a selection for example by mouse-clicking or screen-touching on a block node, connector or arc, and/or by a user drawing a selection region comprising at least a portion of a block node or arc, or the entirety of a connector (e.g., graphical selection box or rectangle), optionally by a select-move-release feature (e.g., by mouse-clicking or screen-touching on a first location, moving of cursor or of screen touch to a second location while maintaining the click or touch, and releasing the click or touch at the second location). Each user-selection of a block node, connector or arc may be automatically followed in real-time by a visual feedback, such as a visual highlighting (e.g., color change or intensity or opacity change) of the selected element or a slight movement (e.g., bounce feedback) of the selected element. Such graphical interactions allow the user to easily edit the 3D modeled objection by manipulating the 2D block representation, and any selection mentioned in the present disclosure may be performed accordingly.

Such a 2D block representation may thus be designed and/or edited easily by a user graphically interacting with the system to instantiate block nodes, to move instantiated block nodes via drag-and-drop actions, and/or to instantiate arcs between connectors for example by selecting one after the other the two connectors, and/or by drag-and-dropping one or more extremities of instantiated arcs to clip each extremity to one connector. Selection of block nodes and/or connector may also trigger the displaying of a dialog box, for example including an editable data field, for the user to enter or modify a value, e.g., using a keyboard or a displayed scroll bar.

Each block node represents a respective operator among a predetermined set of operators. By "predetermined", it is meant functional data (here, a set of operators) supported by the software/application running on or served to the computer system, i.e., part of the computer program instructions forming the application. By "operator", it is meant a set of computer data configured for taking input data, for processing said input data, and for providing output data resulting from the processing. Each operator of the predetermined set of operators thereby has one or more inputs and at least one output. Thus, in the block nodes referred to as being displayed at S10, each input connector represents a respective input of the respective operator represented by the respective block node, and the output connector represents an output of the respective operator represented by the respective block node. In addition to any input represented by a respective input connector, any respective operator may optionally comprise one or more internal parameters that are editable by the user, for example by selecting the operator by the user, displaying one or more editable value fields by the computer system or transitioning an already-displayed value field from editable to non-editable, with a visual feedback displayed to the user to notify said transition, and entering or modifying at least one value of an internal parameter in at least one editable value field.

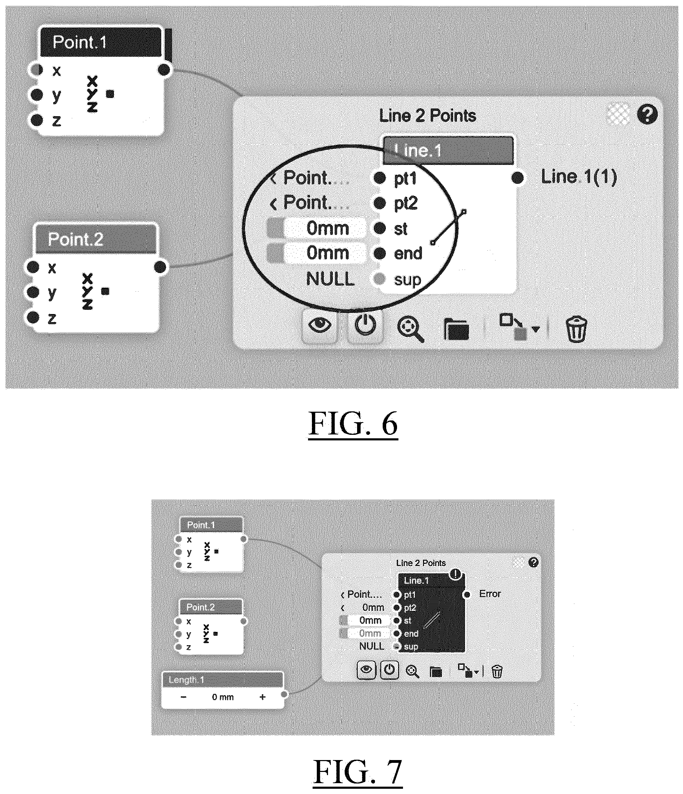

Now, the 2D block representation may optionally comprise additional block nodes that are non-standard in that they have no input connector, either because the input data of the operators represented by such block nodes are hidden to the user, and thus non-editable, or because the block nodes output static data rather than the dynamic result of an operation. The latter option may be the case for example for a "reference" block node, which may provide a common reference frame 0xyz to the design, and/or for primitive block nodes (integer, floating point, length, etc) (e.g., see block node "Length.1" on FIG. 7). Alternatively, such reference and primitives may be represented within the block nodes that they feed.

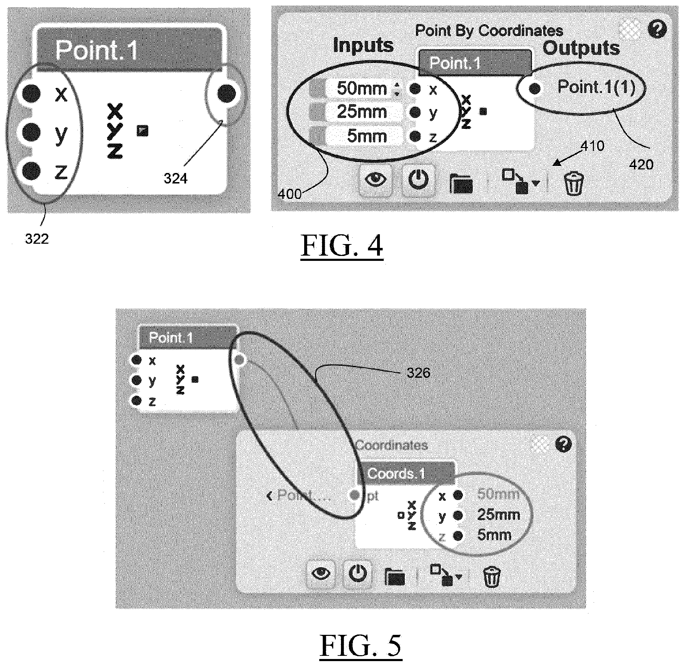

For example, for an operator taking an integer value as an input, this may be represented by a first block node representing the operator and a second block node outputting the integer, and an arc from the output connector of the second block node to a respective input connector of the first block node. The second block node may be an instantiation of a generic integer block node, and the user may parameterize the block node to define the integer value. This allows reusability of the second block node. Alternatively, instead of such a second block node, the integer value may be defined directly at the first block node as an internal parameter (e.g., see data fields 400 on FIG. 4 which allow to directly enter length values). A graphism similar to or identical to or identically-shaped to the graphism of the input connector(s) may be displayed on the first block node and selectable by the user to perform such parameterization, by selecting the graphism and entering or modifying a value in a corresponding editable data field as discussed above.

Additionally or alternatively, the 2D block representation may optionally comprise one or more block nodes each having one or more input connectors that can both, selectively, be connected via an arc to an output connector (for an incoming data flow), or left unconnected but selectable by the user to directly enter a data value at the input connector. This provides flexibility to the user.

Additionally or alternatively, the 2D block representation may optionally comprise additional block nodes that are non-standard in that they have no output connector. This may be the case for example for a "watch" block node, which may allow to watch a "partial result" 3D shape at a particular output connector of the 2D block representation. The output of such a block node is said partial 3D shape, which only needs to be displayed to the user, for example upon selection of the block node, but is not intended to be inputted to any other block node.

Also, one or more of the (standard and/or non-standard) block nodes of the 2D block representation may each comprise several output connectors rather than only one output connector. Each such output connector may be individually selectable by the user, for example by interacting graphically with the output connector. Thus, when the expression "the output" or "the output connector" is applied in the disclosure with respect to a given operator or block node, it must be understood as referring to one of the outputs or to one of the output connectors when the given operator or block node comprises several outputs or output connectors. The outputs and accordingly the output connectors of each such given operator or corresponding block node may follow a predetermined ordering, with at least one output or output connector being defined as the unique and main output or output connector. In case of any ambiguity, when the expression "the output" or "the output connector" is applied with respect to a given operator or block node, it refers to such a main output or main output connector. According to some examples the designing method may comprise selecting one output connector, for example at S20, by graphically interacting with its respective block node and without focusing on the individual output connector to be selected. In such a case, the computer system may directly interpret the selection of the respective block node as a selection of its main output connector.

In the software/application, each operator of the predetermined set of operators has a respective data identifier, meaning that it is referred by a unique data index, name or label, that can be pointed to so as to instantiate the operator in one 2D block representation instantiation, such as the 2D block representation displayed at S10. Each input of each operator further has a respective data identifier, and similarly each output of each operator has a respective data identifier. Such identifiers allow, in the 2D block representation instantiation displayed at S10, to organize a data flow/circulation, wherein data may be marked/identified to be inputted to marked/identified operators, so as to yield marked/identified output data, which in turn may be flowed toward any other process, such as other operators. Said operator identifiers, input identifiers and output identifiers may form one or more indexes. For example, the software/application may manage three indexes, including a first index storing the operator identifiers, a second index storing the input identifiers, and a third index storing the output identifiers. In other words, each identifier is a respective index value (e.g., integer) from a respective index (e.g., a set of integers, optionally continuous and/or from 1 to N). Indexing the input (respectively output) connectors over the set of all input (respectively output) connectors across all operators of the predetermined set, rather than within each respective operator, allows a strong differentiation between the input (respectively output) connectors, that enhances the prediction S40.

Each arc is between a respective pair of connectors, and specifically directed from an (origin) output connector of a first (origin) block node to an (end) input connector of a second (end) block node. Each arc represents data flow from the output connector of the first block node to the respective input connector of the second block node. Since the block nodes each represent a respective operator (sometimes static, i.e., only taking internal parameters as input), each output connector of each block node represents a data value outputted by the operator. An arc originating from said connector represents a flow or circulation of said data value toward the input connector at which the arc arrives. This is interpreted by the application as an intent that the outputted data value of said output connector be inputted as the input of the second block node at said input connector.

A same output connector may be the origin of several arcs, meaning that the data outputted at said output connector is to be flowed to several destinations (several input connectors of other block nodes). Each input connector (e.g., in most cases) may be the end of at most one arc, so as to avoid ambiguities. Alternatively, some input connectors may accept plural incoming arcs, potentially only under some conditions, this being interpreted as a reception of a collection of objects. Optionally and as further detailed later, each input connector may accept a collection of objects via a single arc (e.g., see arcs marked "Size: 3" on FIG. 3, indicating a collection of three objects incoming via a single arc). Further optionally, at least some input connectors may be dynamically duplicable to multiply potential data flow of objects of a same nature. Such duplication may be accompanied by the addition of a specific graphism (e.g., see input connectors "pts" of block node "Spline.1" on FIG. 3, with the dotted line enclosing the connectors to indicate such duplication).

Thus, the 2D block representation is configured such that an execution of the data flow represented by the arcs of the 2D block representation corresponds to a processing of data, starting from one or more root block nodes (i.e., a block node having no input connector or no arc connected to any input connector of the node), and following the data flow represented by the arcs in the arc directions, to sequentially and/or parallelly (depending on the structure of the 2D block representation) process the data according to the operators represented by each encountered block node. The 2D block representation indeed represents a global operation, which corresponds to a compound function of the operators as defined by the arrangement of arcs connecting pair of connectors of block nodes. An execution of the data flow amounts to an evaluation of the compound function.

The execution of the data flow may be performed by a data flow engine of the application. The execution of the data flow may in particular comprise compiling the data flow represented by the 2D block representation into a series of operations, involving the operators, inputs, internal parameters, outputs, as defined by the 2D block representation. The compilation may simplify the calculations according to predetermined rules, such that the series of operations yields the same result as the exact data flow, but does not follow it step-by-step. This is standard from algorithm compilation techniques. The 2D block representation displayed at S10 and the updated 2D block representation to be executed at S110 are each consistent (i.e., compilable), such that the data flow engine effectively succeeds in the compilation. This may be ensured by said 2D block representations each being logically consistent and/or by the data flow engine being configured to resolve any logical inconsistency, for example based on predetermined (e.g., arbitrary) rules.

In examples, the data processing/flow represented by the 2D block representation is finite, for example because the 2D block representation comprises no cycle, that is, no path of arcs that starts at one output connector and arrives at the same output connector. Even more so, the graph corresponding to the 2D block representation may be acyclic. During the designing of the 3D modeled object by designing the 2D block representation by the user, when an attempt to create such a cycle is performed by the user, the computer system may output an alert to indicate a compilation error, or even forbid the creation of the cycle. Alternatively, such cycles may be authorized but with a specific rule in terms of interpreting the implied data flow, such that it is finite. For example, the predetermined set of operators may comprise a loop operator, allowing to generate values according to some looping/iterative algorithm. Retroaction may be allowed for such operator, and this may thus yield arc cycles. The loop operator may have as an input or internal parameter a value controlling the number of iterations/generations, such that it is finite and thus stable.

Alternatively or additionally, each input connector may be connected to an arc such that data effectively flows into the input connector, and/or each input connector may have a default value to be used in case no arc arrives at the input connector. The default value may optionally be a null value, for example if the input represented by the input connector is optional in evaluating the operator of the block node. Similarly, any operator including an internal editable parameter may have a default value of the parameter to be used for evaluating the operator, in case the user does not enter any specific value. When inputted with one or more null values, a block node may evaluate the operator using the one or more null values or ignoring them (e.g., a line operator may have as an optional input a support plane for the line, which may be optional as the line can be drawn using only two points as input), or alternatively replacing them with default values of the concerned default connector(s) and/or internal parameter(s), or yet alternatively, for example if the input is deemed mandatory, indicate an error and/or a non-evaluation of the operator (e.g., and/or outputting an "empty" value). For example the predetermined set of operators may comprise a point-by-coordinates operator, which consists in outputting a geometric point based on input lengths x, y and z, the point having (x,y,z) as coordinates, with respect to a reference frame. The default value of all the length input connectors x, y and z of a block node representing a point-by-coordinates operator may be 0mm. If one of the input connectors x, y and z is not linked to any incoming arc feeding the input connector with a data value, or if the input connector is fed by a null value, the point-by-coordinates operator may use the default 0mm value.

In case a logical inconsistency is introduced or to be introduced in the 2D block representation, the data flow engine may automatically resolve it in any predetermined manner, output an alert, and/or prevent the introduction of the inconsistency.

For at least one specific block node (referred to as a "geometric" block node in the following), for example all block nodes of the 2D block representation, the (main) output of the respective operator represented by each such block node is a respective set of one or more geometrical objects, that is, a set of objects each representing a geometry. The "geometric" block node may be such by nature, that is because it is designed to systematically output geometry, or because of the nature of its input(s) in the 2D block representation, for example because such input is geometric and the operator represented by the "geometric" block node is one that does not change this geometric nature. The predetermined set of operators may in particular comprise a create-list operator, which creates a list of input objects. If the input objects of the operator are geometric, then the corresponding block node is considered to be geometric in the 2D block representation.

With such geometric block nodes, the 2D block representation is configured such that an execution of the data flow represented by the arcs of the 2D block representation outputs a 3D shape representation, in particular the one displayed at S10 or at S120.

The disclosure provides a discussion focusing on geometric block nodes (i.e., block nodes among the at least one specific block node referred to above), but it may apply equally to other types of block nodes. In particular, the selection S20 is presented as being among the at least one geometric block node, but the user may instead perform at S20 a selection not exclusively among the at least one geometric block node, and even exclusively outside the at least one geometric block node, and the remainder of the designing method of FIG. 1 may still be executed, in particular the prediction output at S40, for example because non-geometric operators are included in the dataset used in the pre-training of the machine-learning and/or in the dataset obtained at S25. Since the discussion however focuses on describing how the designing method may help a designer modeling a 3D shape to be eventually produced in the real-word via manufacturing, an emphasis is put on the case of geometric block nodes.

Referring to object-oriented programming, the application manages a predetermined set of object types, and object instances each of one type among the predetermined set of object types. Each object type may be identified with a unique label or marker or index in the application. At least part of the object types are geometrical object types. The 2D block representation instantiates objects among the predetermined set of object types. Each value entered by the user, for example as an internal parameter value of a given block node, is an instance of one of the object types. Each output value provided by an output connector of any block node, and then inputted to an input connector, is an object instance or a collection of object instances, each object instance being of one of the object types.

For (at least) each geometric block node, that is, each block node among the at least one block node for which the output of the respective operator represented by the block node is a respective set of one or more geometrical objects, the output of said respective operator (at a respective output connector) has a dynamic object cardinality. Optionally, the output of the operator of one or more non-geometric block nodes may also have such a dynamic object cardinality. In other words, the output provided by such a block node at the respective output connector may comprise a number of object instances that may be variable depending on the value of one or more internal parameters of the operator provided at the block node and/or on the value and/or cardinality of one or more inputs of the operator provided at the block node. The block node may thus output at the respective output connector a unique object or a collection of several objects depending on the situation.

For example, the predetermined set of operators may comprise a sequence operator, which is designed to output a list of one or more integers depending on the input values of the sequence operator, which inputs may include a lower boundary "inf", an upper boundary "sup", and a number of integers "nb" to be added to the list. The predetermined set of operators may additionally or alternatively comprise a mesh-vertices operator, which consists of outputting as a list all vertices (i.e., geometric points) of an input mesh. The predetermined set of operators may additionally or alternatively comprise a create-list (or build-list) operator, which consists in creating a list from one or more inputs provided to the corresponding block node. Such operators are designed and intended to each output a collection of a variable number of objects (that is, a dynamic number, as it depends on the current instance of the 2D block representation, and in particular its data flow at the location of the relevant block node), even though singular input and/or parameter values may have the operator output a unique (i.e., single) object instead of a collection in an exceptional situation (for example if the "nb" input connector is fed by an integer value equal to 1 in a block node of the sequence operator, which could be an "under-capacity" but authorized use of the operator).

Other examples of operators that the predetermined set of operators may additionally or alternatively comprise and that are intended to rather output a collection of objects of a dynamic cardinality include the following known operators: a rectangular-grid operator (which positions points on a plane in a rectangular pattern), a grid-UV operator (which positions points on a surface), a color-gradient operator, a split-string operator, a normal-rand operator, a sampling operator (which provides a sampling of points in space), a mesh-edges operator and/or a mesh-faces operator (which outputs edges and/or faces of a mesh), a get-items operator, a deepen operator, and/or a flatten operator.

The relevant output connector of the above operator may be marked in the computer system (application) with a "collection" label indicative of such intended output of a collection of objects rather than a unique object. Conversely, output connectors primarily designed for outputting a single object may be marked with a "unique" label indicative of such intended output of a unique object. This marking may be performed in any manner, for example by a database relating output identifiers with their respective labels.

In addition, for (at least) each geometric block node and optionally also for at least one (e.g., each) non-geometric block node, at least one (e.g., each) input of the operator may have a dynamic object cardinality. In other words, the corresponding input connector is configured for receiving a number of object instances that may be variable depending on the origin of the incoming arc. The operator may be configured to expect such a collection and thereby process the collection of input objects as a whole. Each such input connector may thus be associated with a "collection" label or a "unique" label accordingly.

For example, the predetermined set of operators may comprise a spline operator and/or a polyline operator, which are configured to each receive a list of points as input, and to output a spline curve controlled by the list of points or a polyline linking the list of points. In such examples, the operator expects a list of points as input, and thereby processes the collection at once to provide one single output geometric object.

The application may however be configured for managing data flow of collections even at connectors intended for unique objects. This may apply to all connectors of geometric (and optionally even non-geometric) block nodes. The connectors remain labeled as "unique", but depending on the data flow they may be traversed by collections of objects rather than a unique object. This behavior may also apply to connectors expecting collections, such that in this case the connectors each see a collection of collections flowing through them.

In particular, an operator may be designed for processing a single/unique object as input, and the computer system (e.g., data flow engine) may be configured, to ensure compilation, to interpret a data flow of an input collection of objects (instead of just one unique object) as multiple calls of the operator. In other words, the operator may treat each object of the input collection as one single/unique input, compute a respective output, and thereby output a corresponding collection of output objects. The computer system (e.g., data flow engine) may be configured (e.g., at compilation) to only accept the presence of a collection of N objects at one input connector, and a respective unique object at one or more other input connectors, and then evaluate the operator N times, each time using a respective object of the collection for that input connector, and using the respective unique object each time for each other input connector, thereby outputting a collection of N output objects. Alternatively, the computer system (e.g., data flow engine) may be configured (e.g., at compilation) to accept the presence of a collection of N objects at one input connector, and to potentially accept the presence of a collection of objects at one or more other input connectors, but in which case with said collection necessarily having a cardinality of N as well. The execution of the data flow may still evaluate the operator N times in such a case, each time using index i from 1 to N to retrieve an input object from each collection, using the respective unique object each time for each remaining input connector (having no input collection), thereby outputting a collection of N output objects. In case the cardinalities in the inputs are different, the system may output an alert and fail compilation.

For example, the predetermined set of operators may comprise a point-by-coordinates operator as mentioned earlier, and the input connector x may be fed with a list of N length values x1,...xN, instead of a single one, and a single value y1 and a single value z1 for the other input connectors. In such a case the operator outputs a collection of N points: (x1,y1,z1),...(xN,y1,z1). The same operator may be fed with a list of N length values x1,...xN for the x input connector, with a list of N length values y1,...yN for the y input connector, and with a single value z1 for the z input connector. The output of the block node may in such a case be the following collection of N points (thanks to the data flow engine optionally supporting this situation): (x1,y1,z1),...(xN,yN,z1), where xi always equals yi. In case the two lists x1,...xN and y1,...yN did not have the same cardinality, the system would output an alert and fail compilation.

Such a collection of points may then be inputted to an operator expecting a collection of points, such as a spline or polyline operator as mentioned above. In examples, an operator expecting a collection of objects, such as a spline or polyline operator, may receive as input a collection of collections of objects. The operator may be evaluated individually for each collection of objects. In the example of the spline operator, the block node would receive a collection of lists of points. Each list of points yields a respective spline. The block node thus outputs a collection of splines.

Such dynamic object cardinality management provides high ergonomics to the 2D block representation, as a reduced number of blocks may be used to generate collections of geometries. In particular, the 2D block representation may be configured such that a dynamic object cardinality can be used -if desired- to input data to each input connector of each geometric operator block node. This provides high flexibility to the user to generate complex patterns involving collections of objects.

In reference to object-oriented programming in combination with the notion of "type" or "data type" in computer programming, the application manages typed objects, meaning that each object flowing over an arc from an input connector to an output connector, in other words each object passing through or received at an input connector or an output connector, has a data/object type among the predetermined set of object types. Each operator expects objects among one or more possible object types as input, and each operator outputs objects of one or more possible object types, depending on the operator, internal parameter values of the operator, and object type of the input(s) of the operator. For example, the expected object type of the point-by-coordinates operator for each input connector x,y or z is a length object type. The expected objected type of the (main) input connector of the spline operator is a point object type, as the spline operator expects to receive a collection of points to trace a curve passing through said points. As can be seen, the expected type comes in addition to the expected cardinality. An input connector may expect a same object type as another input connector, but the two connectors may expect different cardinalities. Every connector may thus be marked with a label indicative of its expected object type.

Thus, every connector (input or output) of the 2D bock representation may have a static (i.e., pre-defined) cardinality value and a static (i.e., pre-defined) object type. The static cardinality and static object type are information pre-existing to the initial creation of the 2D block representation, and for example stored (persistently throughout the whole design session, whichever modifications of the 2D block representation occur) in a database relating generically connector identifiers to such information (e.g., on non-volatile memory).

The static cardinality value is a value depending on the object cardinality intended for the connector. It may optionally be a binary value indicative of whether the cardinality is 1 or higher than 1, that is, a piece of information indicative of whether the connector is intended for a unique/single object or rather a collection of (several) objects, to pass through the connector. Such a binary value increases accuracy of the prediction S40, as the result of the machine-learning function may depend mostly on whether the cardinality is 1 or higher than 1, rather than on the exact number of objects in the case the cardinality is higher than 1.

The static object type is a piece of information indicative of the object type among the predetermined set of objects types that the connector is intended for. The predetermined set of objects types may comprise generic object types to manage the case where a same operator is intended for different possible specific object types.

The static cardinality value and static object type thus do not depend on the specific use of the connector in the 2D block representation under design.

Thus, in addition to such static values, every connector (input or output) of the 2D bock representation may have a use (e.g., dynamic) cardinality value and a use (e.g., dynamic) object type, also referred to as "inner" cardinality/type or "evaluated" cardinality/type, as opposed to the "pre-defined" (also referred to as "defined") cardinality/type. The use or dynamic object cardinality and the use or dynamic object type are information depending on the current structure of the 2D block representation under design, and they may for example be computed upon need from the 2D block representation, or alternatively, they may be computed and stored in a volatile manner e.g., on volatile memory, such as RAM (such that they are readily readable upon need throughout the design session, but updated upon a modification of the 2D block representation that impacts the values).

The use or dynamic cardinality value is a value depending on the effective object cardinality of the connector, in the current 2D block representation as it is instantiated. The use or dynamic cardinality value may correspond to (i.e., defined in the same domain as) the static cardinality value. It may thus optionally be a binary value indicative of whether the use or dynamic cardinality is 1 or higher than 1.

As explained earlier, a connector having a static cardinality value indicative that the connector expects a collection (e.g., "points" input connector of a spline operator block node, or the integer-list output connector of a sequence operator block node) may have a different use cardinality value. For example, the integer-list output connector may output a single integer if the input/parameter of the sequence operator block node indicative of the number of integers to be outputted has been set to 1. In such a case, the sequence operator block node may have been used at "under capacity", but this may be allowed by the data flow engine. Conversely, the data flow engine may forbid (prevent and/or output an alert) the spline operator being inputted with a unique point in its point-list input connector. Thus, when the cardinality value is a binary value, the use cardinality value is not dynamic as it is always equal to the static cardinality value, i.e. the value indicative that the use cardinality is higher than 1.

The use or dynamic object type is a piece of information indicative of the object type among the predetermined set of objects types that the connector is flowed with. For an output connector of at least one geometric block node and optionally also for an output connector of at least one non-geometric block node, the output of the operator has an object type which is dynamic, meaning that it is variable depending on the current instance of the 2D block representation. In particular, at least one input of the respective operator may have a dynamic object type, such that the corresponding input connector of the respective block node may be fed with objects of different types. The object type at the output connector (i.e., the type of objects outputted at said connector) may then depend on and vary as a function of said input object type.

For example, the predetermined set of operators may comprise one or more transformation operators, one or more extraction operators, and/or one or more list assembly operators. Such operators are operators that do not affect the type of their input, and are rather directed at manipulating them in a type-conserving manner. Such operators may be authorized to be inputted with different object types, since their operations do not depend on the input object type. The predetermined set of operators may for example comprise any one or any combination of the following operators: a translation operator, which translates a geometric object, a rotate operator which rotates a geometric object, a scale operator, which scales a geometric object, an assemble operator, which assembles for example geometric objects together, a sub-elements operator, which extracts sub-parts of an object, a boundary operator, which extracts a boundary of a geometric object (e.g., a boundary curve in case the object is a surface, or a boundary surface in case the object is a volume), and/or a build-list (or create-list) operator, which builds a list out of a plurality of input objects. Such operator block nodes may each have a dynamic input connector and, correspondingly, dynamic output connector. The object type of the output connector may vary depending on the object type of the input connector, which accepts different object types.

Conversely, the predetermined set of operators may comprise one or more geometric operators which do not output any dynamic object type. For such operators, the use/inner object type of the output connector is necessarily the same as the static/defined object type of the output connector. This is the case in particular for geometric operators which generate geometry from scratch. The predetermined set of operators may for example comprise any one or any combination of the following geometry-generating operators: one or more point-generating operators (such as the point-by-coordinate operator), which necessarily output points, a circle-generating operator, one or more curve-generating operators, a line-generating operator, a sphere-generating operator, a plane-generating operator, a mesh-generating operator, a spline-generating operator (as presented earlier), and/or a polyline-generating operator (as presented earlier). The output in such cases is necessarily a constant one among the predetermined set of object types, for example a geometric point object type, a geometric line object type, or a geometric plane object type.

As the 2D block representation may comprise at least one input connector corresponding to an input having a dynamic object type, the predetermined set of object types comprises one or more first object types that are compatible each to one or more second object types. A first object type being compatible to a second object type means that an input connector having the second object type as its static object type, may also accept input data of the first object type. The compatibility relationship is not necessarily symmetric.

For example, the translation operator may expect as an input to be translated an object of a generic geometrical-object (or geometry) type, but the operator may be inputted with objects of a more specific type, such as objects of a geometric-curve type. The translation operator may indeed translate curves with no issue. As another example, the point-by-coordinate operator may have as a static object type for its x, y and z input connectors a length type, but each of these input connectors may accept objects of a real type (i.e., real numbers) or objects of an integer type (i.e., integer numbers), and such input objects may be interpreted as a length, equal to the input value assigned with a predetermined length unit, such as the meter or millimeter unit.

The predetermined set of object types may form a tree of object types, the tree being for example connected and/or having only one single root node. Thus, the object types are all organized according to parent-child relationships in one tree structure, a child type being a specific sub-type of its direct parent type. In other words, the parent type is more generic / encompasses its child type. An object of the child type thus presents all attributes of an object of the parent type, such that an object of the child type may be used as such (i.e., with no conversion) in an operation expecting the parent type. Each non-leaf object type in such a case is dynamic, meaning that connectors having said non-leaf object type as their static object type have a dynamic object type. In particular, each descendant (child or descendent of child, such as grandchild) object type of said non-leaf object type is compatible to said non-leaf object type. This is the case for example for the translation operator as explained above, as the curve object type may be a descendent (e.g., a child) of the geometry object type. Such a compatibility allows to use operators accepting generic object types depending on the situation, for example geometric operators that do not affect type such as those presented above.

In a tree, a parent node of a given node is a node from which an arc originates and arrives at the given node (the arcs being all directed). A descendent node of a given node is a node for which a continuous path of one or more arcs originates from the given node and arrives at the descendant node.

The predetermined set (e.g., tree) of object types may comprise any one or any combination (e.g., all) of the following list of types:
- a generic or undefined (e.g., root) type, and optionally the predetermined set of operators may comprise one or more operators having the generic type as their static object type, for example a create-list operator,
- (e.g., having the root type has a parent or ascendant,) a literal type, a geometry or geometrical object type, and a matrix type,
- (e.g., having the literal type has a parent or ascendant,) a real type, a string type, and a Boolean type,
- (e.g., having the geometry type has a parent or ascendant,) a point type, a curve type, a surface type, and a volume type,
- (e.g., having the matrix type has a parent or ascendant,) a vector type,
- (e.g., having real root type has a parent or ascendant,) an integer type and a magnitude type, the magnitude type having as children a length type and an angle type,
- (e.g., having the curve type has a parent or ascendant,) a line type, and
- (e.g., having the surface type has a parent or ascendant,) a plane type.

At least a portion of the tree may thus consist of the following structure of object types, where the indentation represents parent-child relationships:
- Undefined/root/generic
   o Literal
      ▪ Real
         - Integer
         - Magnitude
            ∘ Length
            ∘ Angle
      ▪ String
      ▪ Boolean
   ∘ Geometry / geometrical object
      ▪ Point
      ▪ Curve
         - Line
      ▪ Surface
         - Plane
      ▪ Volume
   ∘ Matrix
      ▪ Vector

The 2D block representation displayed at S10 may comprise, for each respective type of the any one or any combination (e.g., all) of the list of types, at least one connector of which static/defined type is the respective type.

Additionally or alternatively, when the predetermined set of types is a tree, the 2D block representation may comprise, for each respective leaf type of the any one or any combination (e.g., all) of the list of types, at least one connector of which use/inner type is the respective type.

In addition or alternatively, the predetermined set of object types (e.g., tree) may comprise one or more first object types each convertible into one or more respective second object types. Each such first object type convertible into a respective second object type may be different from and not a child or descendant of said respective second object type. The first object type may however possibly be an ascendant (i.e., parent or ancestor) of the second object type. By "convertible", it is meant that the computer system / application / data flow engine comprises a respective conversion algorithm configured for turning/converting each such first object type into such a respective second object type. Thus, the algorithm/conversion may be executed each time an object of the first object type is inputted to an input connector expecting (having as static object type) an object of the second object type. As a result, each first object type convertible into a respective second object type is thereby compatible to said respective second object type. This is the case for example of the integer object type or the real object type, which may both be converted into the length object type. As mentioned above, the predetermined algorithm may in such a case consist in taking the input integer or real value as is, and assigning said value with a predetermined length unit. Such a compatibility allows flexibility to the user, who is not bound to have exact type matching or descendance when creating arcs between connectors. This may prove extremely ergonomic, as the predetermined set of object types may comprise more than 10, 50 or 100 different object types, making it difficult for the user to always select the one and only object type that would be authorized whichever the situation.

By convention, the dynamic object type of a collection of objects of different object types is the closest ascendent object type in the tree which is common to all object types of the collection.

The system (e.g., data flow engine) may for example support any one or any combination (e.g., all) of the following convertibility rules:
- the real type is convertible into the integer type (e.g., by using a floor or ceiling function), into the length type (e.g., by adding a unit, which may be systematically the meter unit), and/or into the angle type (e.g., by adding the radian unit),
- the integer type is convertible into the length type (e.g., by adding a unit, which may be systematically the meter unit or the millimeter unit), and/or into the angle type (e.g., by adding the radian unit),
- the Boolean type is convertible into the integer type (e.g., True is converted into 1 and False is converted into 0),
- the point type is convertible into the vector type (e.g., the coordinates of a point become as is the coordinates of the vector),
- the curve type is convertible into the plane type, optionally only if the curve is planar, otherwise an error is outputted (e.g., taking the plane or any plane containing curve),
- the line type is convertible into the vector type (e.g., by taking a unit vector direct along the line),
- the plane type is convertible into the vector type (e.g., by taking a unit vector normal to the plane), into the line type (e.g., by taking an infinite line normal to the plane), and into the matrix type (e.g., by considering a 4x4 transformation matrix, the geometries - including the planes - being oriented, with a first column of the matrix representing an X direction of the plane, a second column representing a Y direction of the plane, a third column representing a Z direction of the plane, and a fourth column representing a position of an origin O of the plane; such a conversion can serve to express a change of frame in a facilitated manner), and/or
- the volume type is convertible into the surface type (e.g., by taking a boundary surface of a volume).

The 2D block representation displayed at S10 may comprise at least one occurrence of each convertibility of the list (i.e., at least once, an object is converted according to each rule at an input connector).

The system/application/engine may be configured such that a first object type is compatible to a second object type only if the first object type is a descendant of the second object type or the first object type is convertible into the second object type. Otherwise, and if the first object type is not identical to the second object type, the system may output an error, indicative of an incompatibility. This puts a constraint on the design, avoiding ambiguities.

Still referring to FIG. 1, the designing method comprises, after and/or while the displaying S10, by a user interacting graphically with the 2D block representation, for example as discussed above, performing S20 a selection of one output connector. The case of geometric design is here discussed, where the user is shaping the final product to be manufactured, although the same type of user-interaction may be supported for non-geometric design.

The output connector selected at S20 may either be not connected to any arc or already be connected to one or more arcs. For example, a user might wish to attach a new block node to an output connector that is already linked via arcs to other block nodes, as illustrated in FIG.s 17 and 18.

The selection performed at S20 may comprise the user graphically acting on the output connector, for example the user clicking or touching the output connector. Alternatively, the selection performed at S20 may comprise the user graphically acting on a block node possibly at other locations than the output connector displayed on the block node. The system may then interpret such action as a selection of an output connector, for example the (main) output connector. For example, the block node may optionally have one, and only one, output connector and the system may then interpret such action as a selection of the output connector. The system may optionally support both alternatives (i.e., graphically acting on the output connector and/or on the block node). In examples, the designing method is repeated, including at least once implementing the first alternative and at least once implementing the second alternative.

The block node of the output connector selected at S20 has at least one (e.g., exactly one) antecedent block node. By "antecedent block node" of a respective block node, it is meant another block node having at least one output connector which is connected (e.g., with an arc) to at least one input connector of the respective block node. For example, the respective block node may have one, and only one, input connector and the antecedent block node may have one, and only one, output connector, said output connector being connected with an arc to the input connector of the respective block node.

The block node of the selected output connector (at S20) may be evaluated/evaluable. For example, the data may effectively flow through the block node (e.g., all the required input connectors of the block nodes may be connected to other block nodes). Thus, the selected output may have a use/inner (e.g., dynamic) object type.

The designing method may then comprise different actions using a pre-trained (i.e., already trained/learnt) machine-learning function, for example a pre-trained deep-learning neural network, and a dataset based on a plurality of previously performed designs. These actions may be triggered automatically upon (i.e., as soon as and as a direct result) the user performing the selection at S20, or alternatively automatically upon the user afterwards launching a specific functionality of the system.

The designing method notably comprises obtaining a pre-trained machine-learning function. The obtaining of the pre-trained machine-learning may comprise retrieving (e.g., from local or remote memory) or receiving (e.g., from a remote system) the pre-trained machine-learning function. The obtaining may also comprise obtaining a machine-learning function (not pre-trained, for example, with randomly instantiated weights and parameters) and training the machine-learning function, thereby obtaining the pre-trained machine-learning. The obtaining may further comprise obtaining a training dataset and training the machine-learning based on the training dataset. The training of the machine-learning function and the obtaining and/or generating of the training dataset will be discussed further below in the disclosure.

The pre-trained machine-learning function may have been trained to obtain as input the data identifier (e.g., index) of an operator, the data identifier (e.g., index) of an output connector of a block node representing the operator, and an object type (e.g., index in the indexation of the predetermined set of object types) of the output connector. The pre-trained machine-learning function may have further been trained to provide as output one or more operators among the predetermined set of operators (e.g., ranked using a score or probability).

The designing method further comprises obtaining S25 a dataset including pieces of data. The obtaining S25 may comprise retrieving (e.g., from local or remote memory) or receiving (e.g., from a remote system) the dataset. The dataset is based on a plurality of previously performed designs. The plurality of previously performed designs may include a multitude of "default" previously performed designs not created by the user (e.g., stored in a local or remote memory). The plurality of previously performed designs may in particular comprise 3D modeled objects each including a respective 2D block representation having been designed by multiple other users and/or in the same or other organizations, and having been archived in a retrievable fashion. The designing method thereby builds upon previously created knowledge. The plurality of previously performed designs may comprise, for example in majority (more than 50%) or for substantially all (e.g., more than 90%) or for all (100%), finalized designs. The plurality of previously performed designs may comprise, for example in majority (more than 50%) or for substantially all (e.g., more than 90%) or for all (100%), designs that fully represent the shape of product to be manufactured that may indeed be manufactured as such (i.e., without further design). Additionally or alternatively, the plurality of previously performed designs may comprise (e.g., consist of) a multitude of designs previously created by the user and/or chosen by the user.

The dataset may be obtained by retrieving 2D block representations of the previously performed designs. Such 2D block representations may be retrieved from internal databases and/or catalogues of previous designs that have been completed and validated. In examples, each block node of at least one (e.g., each) 2D block representation of a respective design of the plurality of previously performed designs may be a block node from which data effectively flows, that is, which is evaluated or evaluable, e.g., which has all the input connectors connected to respective blocks.

The dataset may be different from the training dataset used for training the machine learning function. For example, each entry / piece of data of the dataset may have a different format from those of the training dataset. The dataset and the training dataset may or may not be based on the same plurality of previously performed designs. In an example, the training dataset may be based on a set of "default" previously performed designs not created by the user. As such, the training dataset may not depend on the user. The dataset may be based on at least one (e.g., each) such designs and, optionally and additionally, on user-created or user-chosen previously performed designs. Alternatively, the training dataset and the dataset may be based on completely different previously performed designs.

Notably, the dataset obtained at S25 may be dynamically / iteratively modified during the design process, taking into account in real time all the design selections of the user. In examples, the designing method is repeated and at each repetition, the dataset obtained at S25 may be different (e.g., may be updated based on the previous repetitions). Thus, the prediction outputted at S40 may be (more and more) based on the previous choices of the user. Therefore, the designing method may adapt to the user automatically while the user designs on the system.

The designing method may comprise storing the dataset in a non-volatile memory (e.g., either in a local or remote memory) after each update and/or at the end of each session. Thereby, the designing method may ensure that the dataset is always updated with all the previously performed designs of the user.

Each piece of data of the dataset obtained at S25 comprises a tuple (i.e., a plurality of data elements linked/related together). The tuple comprises a first operator. The first operator is represented by a first block node in a design. The design is a design among the plurality of previously performed designs. The tuple comprises a second operator. The second operator is represented by a second block node in the design. The second block node has an output connector connected to a respective input connector of the first block node. The tuple comprises a third operator. The third operator is represented by a third block node. The third block node has a respective input connector connected to a respective output connector of the first block node. The tuple further comprises an object type. The object type is the object type of the respective output connector of the first block node to which the respective input connector of the third block node is connected. The object type may be the use/inner (e.g., dynamic) object type.

In examples, the third connector may have one, and only one input connector connected to the respective output connector of the first block node. In other examples the third connector may have multiple input connectors, each of which may or may not be connected to an output connector (e.g., the respective output connector) of the first block node.

Thus, the tuple may have at least one "instantiation" in at least one design among the plurality of previously performed designs. Each of the instantiations of the tuple in a design of the plurality of previously performed designs comprises a first block node, a second block node, and a third block node of the design. The first operator is represented by the first block node in the design. The second operator is represented by the second block node in the design. The second block node is an antecedent of the first block node, that is, the second block node has at least one (e.g., exactly one) output connector connected (e.g., with one or more arcs) to at least one (e.g., exactly one) input connector of the first block node. The third operator is represented by the third block node in the design. The first block node is an antecedent of the third block node. Thus, the third block node has a respective input connector connected to a respective output connector of the first block node. The object type is the object type of the respective output connectors of the first block node. The object type may be the use/inner (e.g., dynamic) object type of the respective output connector.

Each piece of data of the dataset obtained at S25 further comprises a weight. The weight depends on an extent of instantiation of the tuple comprised in the piece of data in the plurality of previously performed designs. At least one (e.g., each) weight may be a number, e.g., a non-negative integer or a strictly positive integer. The weight and/or the number may represent an availability and/or presence of instantiations of the tuple in the plurality of previously performed designs.

Each tuple may have none, or one or more instantiations in each of the designs of the plurality of previously performed designs. The instantiations in a same design may intersect. For example, the first block of an instantiation may be a first block or a second block of another instantiation. In examples, two instantiations may be considered different instantiations when they have at least one of the block nodes (among the first, second, and third) that are not identical, or an object type that is not identical.

The weight may be correlated (e.g., linearly depend on) to the number of instantiations of the tuple in each one of the designs of the plurality of previously performed designs. Thus, the weight may increase proportionally with the number of instantiations the tuple has.

For example, the weight may be a "count" of the number of instantiations, e.g., with coefficients. For example, the designing method may comprise assigning to each design of the plurality of previously performed designs an importance value (e.g., a numerical coefficient), and the (composite) weight may be a sum over all the designs of the plurality of previously performed designs of a number of instantiations that the tuple has within the design multiplied by the importance value of said design. For example, the (composite) weight w may be given by w = Σ*_{dED} I_{d}N_{d},* where d represents a design of the plurality of previously performed designs *D, N_{d}* represents the number of instantiation that the tuple has within the design *d*, and *I_{d}* represents the importance value of the design *d.* The importance value (e.g., *I_{d}*) may always be one (e.g., *I_{d}* = 1 for all *d*), and the weight may be the total count of instantiations. Alternatively, the importance value may depend on whether the design was previously performed by the user. For example, the importance value (e.g., *I_{d}*) may be 1 if the design is a default design (e.g., not performed by the user) and may be higher than 1-such as 2, or 10-if the design was previously performed by the user. For example, *I_{d}* may be equal to 1 if *d* is a design not performed by the user and 2 (or 10) if *d* is a design performed by the user.

Thus, the weight may be representative of an extent of instantiation performed by previous users and/or performed by the current user. The choices of the user may add more to the weight (in proportion) than those of previous users. Thereby, the designing method may allow increased personalization of the prediction, thereby better predicting the intentions of the user, and increasing the ergonomics of designing an object to be manufactured.

The obtaining S25 of the dataset may comprise generating the dataset from the plurality of previously performed designs. The generating may comprise receiving or retrieving the plurality of previously performed designs (e.g., default designs and/or user-created/chosen designs). The generating may include, for each tuple that has at least an instantiation in at least one of the plurality of previously performed designs, generating an entry of the dataset comprising the tuple. The generating may include computing the weight of the tuple as explained above, e.g., by using the formula *w* = *Σ_{d} I_{d}N_{d}.* As the dataset may be stored and updated between sessions, the designing method may only require generating the entire dataset once per user.

The designing method further comprises providing S30 to the machine-learning function input data required for the machine-learning function to be evaluated. Thus, the machine-learning function may then be evaluated with such input data.

The input data depend on the selection performed at S20, and the input data include at least the data identifier (e.g., index) of the respective operator represented by the block node of the selected output connector, the data identifier (e.g., index) of the selected output connector, and an object type (e.g., index in the indexation of the predetermined set of object types) of the respective output connector. Such data allows the results of the machine-learning function to be used at S40 to output a prediction of one or more operators among the predetermined set of operators.

The designing method further comprises outputting (S40), based on a result of the machine-learning function and on the dataset, a prediction of one or more operators among the predetermined set of operators. The prediction may be a guess by the system of one or more operators that the user may want to instantiate next at this stage of the designing method. The prediction may output a single operator, for example the most likely operator among all operators of the predetermined set of operators, or several operators ranked by (e.g., decreasing) score (e.g., probability) of the user wanting to instantiate them. The machine-learning function and the dataset thus aid the user in the designing method, in particular by proposing one or more operators at different stages of the design, such that the user need not systematically search for operators to be instantiated in the fully manual tradition and cumbersome manner. This may prove extremely ergonomic, as the predetermined set of operators may comprise more than 50, 100, or 200 different operators. Moreover, the prediction may propose one or more operator(s) that users frequently select (e.g., in the plurality of previously performed designs) and that are therefore likely to be the most relevant operator(s). Additionally, because the dataset can vary from the user to another, the prediction may be customized for the current user, i.e., the prediction may reflect user's prior selections.

In examples, the prediction may be based on a score depending both of the machine-learning function and the dataset. For example, the score of a given operator may depend on the weight of a respective tuple determined form a first operator, a second operator, a third operator, and an object type. The first operator may be the respective operator represented by the block node of the selected output connector. The second operator may be the respective operator represented by the antecedent block node of the block node of the selected output connector. The third operator may be the given operator. The object type may be the object type of the selected output connector, e.g., the use/inner (e.g., dynamic) object type.

For example, the score may increase proportionally with the weight. Thus, if the user has consistently selected a given operator in instantiations comprising a first operator, a second operator, and an object type, then the prediction may more likely rank highly the given operator (e.g., be the given operator).

The outputting S40 may comprise obtaining as a result of the machine-learning function a first score (e.g., a probability) of each given operator of the predetermined set of operators. The first score / probability may consist of a prediction of one or more operators among the predetermined set of operators, the prediction using exclusively the output of the machine-learning function.

The outputting S40 may comprise determining a second score of each given operator of the predetermined set of operators. The second score may consist of a prediction of one or more operators among the predetermined set of operators, the prediction using exclusively the dataset. The second score of a given operator may represent a (e.g., weighted) frequency of a respective tuple in the dataset.

The respective tuple may be determined form a first operator, a second operator, a third operator, and an object type (e.g., as explained above). The first operator may be the respective operator represented by the block node of the selected output connector. The second operator may be the respective operator represented by the antecedent block node of the block node of the selected output connector. The third operator may be the given operator. The object type may be the object type of the selected output connector. The object type of the selected output connector may be the use/inner (e.g., dynamic) object type.

The "frequency" may be a normalized weight, that is the weight of the respective tuple normalized by all the possible weights of corresponding tuples comprised in the dataset similar to the respective tuple. For example, the frequency of a respective tuple may be a frequency (e.g., relative weight) of the respective tuple among all (corresponding) tuples of the dataset having the same first operator, second operator, and object type as the respective tuple.

Thus, the second score may represent a frequency (e.g., weighted frequency or relative weight) or proportion of the respective tuple among all (corresponding) tuples of the dataset having the same first operator, second operator, and same (or compatible) object type as the respective tuple. The designing method may comprise setting the second score to a predetermined value (e.g., 0 or 0.1) if no pieces of data of the dataset comprise the respective tuple.

The second score Score₂(*Oᵢ*) of an operator *Oᵢ* may be given by the formula: ${Score}_{2} \left({O}_{i}\right) = \frac{{w}_{i}}{{\sum }_{j} {w}_{j}}$ where {*Oⱼ*}*ⱼ* is a set of operators comprising the operator *Oᵢ* and comprised in the predetermined set of operators. Each operator *Oⱼ* may be the third operator of a tuple of the dataset of which first operator, second operator, and object type are the same as those of the (above defined) respective tuple of *Oᵢ*. That is, for each *j*, the first operator / second operator / object type of the tuple having as third operator *Oⱼ* may be the same as the first operator / second operator / object type of the respective tuple of *Oᵢ*. Notably, the tuple having as third operator *Oⱼ* may be defined as the respective tuple of *Oⱼ*. The quantity of *wⱼ* may be the weight of the tuple having as third operator *Oⱼ*. The quantity Score₂(*Oᵢ*) may be a predetermined value (e.g., 0 or 0.1) if no pieces of data of the dataset comprise the respective tuple of *Oᵢ*.

The outputting S40 may comprise combining the first and second score, thereby obtaining a third score of each operator of the predetermined set of operators. Thus, the prediction of one or more operators among the predetermined set of operators may be based on the third score. For example, the prediction may be a single operator corresponding to the highest third score or several operators ranked by (e.g., decreasing) third score.

The combining of the first and second score may comprise different arithmetic operations and implemented in different ways. For example, the third score of each operator of the predetermined set of operator may be a convex combination of the first and the second score of the operator. The weight of the convex combination may represent the importance given to the output of the machine-learning function and of the dataset.

The combining may comprise setting to a predetermined value (e.g., 0 or 0.1) the second score of an operator, if such second score was not previously defined.

For example, the third score Score₃(*O*) of an operator *O* of the predetermined set of operators may be given by the formula: ${Score}_{3} \left(O\right) = \frac{c ⋅ {Score}_{1} \left(O\right) + c ′ ⋅ {Score}_{2} \left(O\right)}{c + c ′}$ where:
- *c* and *c'* are numerical coefficients (e.g., *c* = 2, and *c'* = 3),
- Score₁(*O*) is the first score of the operator *O*, and
- Score₂(*O*) is the second score of the operator *O*.

To improve accuracy/usefulness of the prediction, the input data of the machine-learning function provided at S30 may further comprise a value depending on an object cardinality of the selected output connector, for example a binary value indicative of whether the cardinality is 1 or higher than 1. In other words, the prediction may consider as input the fact that the data flowed at the selected output connector is rather a unique object or a collection of objects. In a 2D block programming application allowing such collections, and in particular dynamically, this may greatly influence the nature of the operator that the user may want to instantiate next.

Among the input data provided at S30, the use/inner (e.g., dynamic) object type and/or the use/inner (e.g., dynamic) object cardinality (e.g., binary) value may be known for the output connector selected at S20, because the output connector is an output connector of a block node from which data effectively flows, that is, which is evaluated or evaluable. In such a case, the object type and/or the object cardinality value provided at S30 for said at least one respective connector may be, respectively, the use/inner (e.g., dynamic) object type and/or the use/inner (e.g., dynamic) object cardinality value.

For example, if the user selects at S20 the output of a translation operator block node which is correctly connected at its input connectors and thus evaluated/evaluable, the input data provided at S30 to the machine-learning function, the respective tuple of the translation operator that may be used to compute the second score, and thus the prediction outputted at S40 may vary depending on the dynamic value of the object type at the selected output and on the dynamic value of the object cardinality value. The prediction may in particular be different if the translation operator block node outputs a unique point, a collection of points, a unique curve, or a collection of curves. The four cases may indeed occur for a same translation operator, depending on whether the block node is inputted with a unique point, a collection of points, a unique curve, or a collection of curves. The data identifier of the respective operator and the data identifier of the respective selected connector are the same in all four cases (identifier of translation operator and identifier of outputted geometry - one and only output - of the translation operator). But the four cases may all yield different predictions, as the user is not likely to want to perform the same operation on the output in the four cases. For example, if the output is a unique point, the user may potentially want to use it to combine with another point and draw a line. The line operator should in such a case be predicted as a next operator wanted by the user. If the output is a collection of points, the user may potentially want to next draw a polyline or a spline using said collection of points. Such spline and polyline operators should in such a case be predicted as a next operator wanted by the user.

The machine-learning function may be a deep-learning neural network, for example a multilayer perceptron, or alternatively a Transformer network, a graph neural network, or a Long Short Term Memory (LSTM) network. The machine-learning function may comprise more than 1 million trainable parameters and/or less than 10 or 5 million trainable parameters. The machine-learning function may comprise more than 2 layers and/or less than 20 layers. Such values allow for a reasonable memory consumption, a fast evaluation of the machine-learning function, while achieving high accuracy. The prediction S40 (and thereby the displaying S50) may thus be performed real-time upon performing the selection at S20. The predetermined set of operators may indeed comprise more than 50, 100, or 200 different operators, and/or less than 1000 different operators. And the predetermined set of object types may comprise more than 10, 50, 100 different object types, and/or less than 500 different object types.

The use of machine learning and the dataset to perform the prediction at S40 allows, based on previous examples, to avoid computing a statistic for each potential combination, and then output a prediction based on such statistic. The number of potential combinations is particular high, notably in case the predetermined set of operations is large, such that computing such a statistic may be very time-consuming, and storing its values may consume much space. Also, evaluating the statistic would consume much time on fly, preventing any real-time behavior.

The machine-learning function may be obtained via a training method which comprises obtaining a training dataset comprising training examples, and training the machine-learning function based on the training dataset, for example to minimize a loss over a portion of the training dataset (such as 80%) and validate performance over a remaining portion of the training dataset (such as 20%). The training may be performed epoch-by-epoch and/or batch-by-batch, according to any machine-learning technique adapted to the architecture of machine-learning function (e.g., multilayer perceptron, Transformer network, graph neural network, or LSTM network).

Each training example includes, as prediction input (i.e., to be inputted to the prediction of S40), an output connector (alike those selected at S20), a respective geometric block node, the data identifier of the respective operator, the data identifier of the output connector, an object type of the output connector, and optionally a value depending on an object cardinality of the output connector, for example a binary value indicative of whether the cardinality is 1 or higher than 1, if the result of the machine-learning function is to be inputted with such an object cardinality (e.g., binary) value. The training example further includes, associated to such prediction input (ground truth input), as prediction output (ground truth output), an operator. As a result, such offline training may result in a machine-learning function configured to be used online at S30-S40.

The training dataset may be obtained by retrieving 2D block representations each of a respective (e.g., completed) 3D modeled object representing a respective product to be manufactured, and that may have been previously designed by a user (e.g., using the same 2D block representation application), and optionally that may have further been manufactured. Such 2D block representations may be retrieved from internal databases and/or catalogues of previous designs that have been completed and validated. Such 2D block representations may be, or comprise at least a portion of, the 2D block representations of the plurality of previously performed designs represented by the dataset.

From such retrieved 2D block representations, the training method may determine sequences of design operations whereby the user has (very likely) performed a selection, among at least one block node, of one output connector, such as at S20, and then the user has instantiated, such as at S60, an operator to be connected to the selected output connector, such as at S70. The training method may consider such sequences within patterns, each pattern comprising an output connector connected via an arc to a block node. The training examples may be determined accordingly from such patterns. Optionally, all such patterns in each retrieved 3D modeled object may be considered and processed for creating, from each pattern, at least one training example, at least initially (but training dataset normalization may then delete some of these examples).

A pattern may for example comprise an output connector connected to an input connector. The obtaining of the training dataset may include forming one training example including, as prediction input, the output connector, and as prediction output, the operator represented by the block node of the input connector.

Since the patterns are from completed designs, each connector of each pattern can be evaluated. Thus, the training dataset may comprise as prediction input, for each respective output connector, a use/dynamic object type and/or a use/dynamic object cardinality (e.g., binary) value.

The training dataset may be normalized, to avoid biases in the training, as they may otherwise be amplified in particular in view of the above data augmentations.

Coming back to the designing method of FIG 1, the designing method comprises, based on the prediction outputted at S40, displaying S50 a graphical representation of at least one operator of the prediction, for example at least the most probable operator according to the prediction, or a list of operators (for example less than 10), optionally ranked by (e.g., decreasing) order of score (e.g., the third score, or probability) including and starting from the most probable operator according to the prediction. The displaying S50 may be performed in a dialog box and/or in the form of a displayed menu, showing a list of icons and/or textual name for each of the at least one predicted operator. The displaying S50 may be performed automatically and/or real-time upon the outputting S40 being complete, thus real-time after the selection at S20 or the subsequent triggering of the functionality that launched the prediction S30-S40.

The designing method then comprises the user selecting S60 an operator among the display of S50, for example graphically, e.g., by clicking or touching on the corresponding icon and/or textual name. The operators displayed at S50 could be replaced by new proposed operators, for example if the user decides to perform a traditional manual search. The search bar may be displayed in the same menu, to reduce the number of actions from the user. But FIG. 1 shows an example where the user selects at S60 an operator among the prediction outputted at S40.

The designing method may then comprise, increasing by a predetermined number the weight of a respective tuple of the dataset. The respective tuple may be defined by a first operator, a second operator, a third operator, and an object type, as above. The first operator of the respective tuple is the respective operator represented by the block node of the selected output connector. The second operator of the respective tuple is the respective operator represented by the antecedent block node of the block node of the selected output connector. The third operator of the respective tuple is the selected operator. The object type of the respective tuple is the object type of the selected output connector. For example, the object type may be the use/inner object type of the selected output. The predetermined number may be 1, or may be any value bigger than 1, such as 2 or 10. Higher values increase the importance of the choices for the user within the prediction outputs at S40.

The increasing by a predetermined number of the weight of a respective tuple of the dataset may also comprise, whenever no pieces of data of the dataset comprise the respective tuple, generating a new entry of the dataset, the new entry having as tuple the respective tuple and as weight the predetermined number (e.g., 1, 2, or 10).

Thereby, the designing method may comprise, after each selection, updating the dataset, iteratively learning and adapting to the choices of the user. Thus, the designing method may always output a best prediction for the user, which may be different to a best solution of another user in the same context. For example, the designing method may comprise multiple iterations of the steps S20-S120 and after each execution of S60, the designing method may comprise increasing by a predetermined number the weight as described above, thereby obtaining at the next iteration of S25 a dataset that represents more the choices of the user.

The designing method then comprises adding S70 to the 2D block representation a block node representing the selected operator, thus instantiating the selected operator, and updating S80 the display of the 2D block representation, at least by displaying the added block node. The adding S70 and the updating S80 of the display may be performed automatically/real-time and seamlessly upon the selection S60 by the user being complete.

The designing method then comprises adding S90 to the 2D block representation an arc between the output connector selected at S20 and a respective connector of the block node added at S70, thereby obtaining at S90 an updated 2D block representation. Such addition of arcs may be performed automatically/real-time and seamlessly upon the selection S60 being complete, or alternatively by the user, using the drag-and-drop arc creation and positioning techniques mentioned earlier.

The designing method then comprises updating S100 the display of the 2D block representation, at least by displaying the added arc. The updating S100 of the display may be performed automatically/real-time and seamlessly upon the adding S90 being complete. In case the designing method is automatic from S70 to S90, the updating S100 of the display may be confounded/simultaneous and seamless with the updating of the display at S80.

The designing method may comprise, optionally automatically/real-time and seamlessly upon the updating S100 being complete, executing S110 the data flow represented by the arcs of the 2D block representation as updated at S100, thereby outputting an updated 3D shape representation, and displaying S120 the updated 3D shape representation, simultaneously to the displayed updated 2D block representation. The designing method thus allows an eventual update of the 3D shape representation at S120, which provides a visual feedback to the user of the edition conducted via S20 and S60 and optionally S90.

The designing method may be repeated and interlaced with other designing steps in a designing phase, for example for the user to add block nodes and arcs in other manners, for example according to the standard graphical interaction design capabilities of the 3D block representation application, so as to eventually yield a complete and exact shape of the product to be manufactured. The 2D block representation and/or 3D shape representation may then be inputted to a manufacturing process, which may output one or more physical instances of the product to be manufactured with the exact same shape as the one eventually reached at the end of the designing phase. The designing method and/or machine-learning process may thus be included in a manufacturing process of the product to be manufactured (e.g., a mechanical part of an assembly of mechanical parts).

The designing method thus generally manipulates modeled objects, in particular the 2D block representation and the 3D shape representation. A modeled object is any object defined by data stored e.g. in the database. By extension, the expression "modeled object" designates the data itself. According to the type of the system, the modeled objects may be defined by different kinds of data. The system may indeed be any combination of a CAD system, a CAE system, a CAM system, a PDM system and/or a PLM system. In those different systems, modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a modeled object may be defined by data corresponding to any combination of these systems. A system may thus well be both a CAD, CAE, PLM and/or CAM system, as will be apparent from the definitions of such systems provided below.

By CAD solution (e.g. a CAD system or a CAD software), it is additionally meant any system, software or hardware, adapted at least for designing a modeled object on the basis of a graphical representation of the modeled object and/or on a structured representation thereof (e.g. a feature tree), such as CATIA. In this case, the data defining a modeled object comprise data allowing the representation of the modeled object. A CAD system may for example provide a 3D shape representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts. The specifications (also referred to as "CAD specifications") of a CAD model may be stored in a CAD file as explained above, but may also be stored as distributed CAD data on one or more storage, i.e. on a cloud environment.

In the context of CAD, a modeled object may typically be the 3D modeled object, e.g. representing a product such as a part or an assembly of parts, or possibly an assembly of products. The 3D modeled object may be a manufacturing product, *i.e.* a product to be manufactured. By "3D modeled object", it is meant any object which is modeled by data allowing its 3D shape representation. A 3D shape representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D shape representation facilitates design (i.e. increases the speed at which designers statistically accomplish their task). This speeds up the manufacturing process in the industry, as the design of the products is part of the manufacturing process.

The 2D block representation and the corresponding 3D shape representation modeled object may represent the geometry of a product to be manufactured in the real world subsequent to the completion of its virtual design with for instance a CAD/CAE software solution or CAD/CAE system, such as a (e.g. mechanical) part or assembly of parts (or equivalently an assembly of parts, as the assembly of parts may be seen as a part itself from the point of view of the designing method, or the designing method may be applied independently to each part of the assembly), or more generally any rigid body assembly (e.g. a mobile mechanism). A CAD/CAE software solution allows the design of products in various and unlimited industrial fields, including: aerospace, architecture, construction, consumer goods, high-tech devices, industrial equipment, transportation, marine, and/or offshore oil/gas production or transportation. The 3D modeled object designed by the designing method may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

The 3D shape representation may be a B-rep. The 3D shape of the part displayed on the screen of the computer when the modeled object is represented may be (e.g. a tessellation of) the B-rep.

By PLM system, it is additionally meant any system adapted for the management of a modeled object representing a physical manufactured product (or product to be manufactured). In a PLM system, a modeled object is thus defined by data suitable for the manufacturing of a physical object. These may typically be dimension values and/or tolerance values. For a correct manufacturing of an object, it is indeed better to have such values.

By CAE solution, it is additionally meant any solution, software of hardware, adapted for the analysis of the physical behavior of a modeled object. A well-known and widely used CAE technique is the Finite Element Model (FEM) which is equivalently referred to as CAE model hereinafter. An FEM typically involves a division of a modeled object into elements, i.e., a finite element mesh, which physical behaviors can be computed and simulated through equations. Such CAE solutions are provided by Dassault Systèmes under the trademark SIMULIA^{®}. Another growing CAE technique involves the modeling and analysis of complex systems composed a plurality of components from different fields of physics without CAD geometry data. CAE solutions allow the simulation and thus the optimization, the improvement and the validation of products to manufacture. Such CAE solutions are provided by Dassault Systemes under the trademark DYMOLA^{®}. CAE may be used to ensure that various structural requirements (such as, but not limited to, mass, stiffness, strength, durability) are achieved by a new CAD model. Some of these requirements may be called Key Performance Indicators (KPIs). For many industrial products (for example cars, airplanes, consumer packaged goods, hi-tech), these KPIs are in conflict e.g. lower mass usually causes lower stiffness. Thus, optimization methods are often applied to find the best trade-off between the KPIs.

By CAM solution, it is meant any solution, software of hardware, adapted for managing the manufacturing data of a product. The manufacturing data generally include data related to the product to manufacture, the manufacturing process and the required resources. A CAM solution is used to plan and optimize the whole manufacturing process of a product. For instance, it may provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. For example, a CAM solution may provide the information regarding machining parameters, or molding parameters coherent with a provided extrusion feature in a CAD model. Such CAM solutions are provided by Dassault Systèmes under the trademarks CATIA, Solidworks or trademark DELMIA^{®}.

CAD and CAM solutions are therefore tightly related. Indeed, a CAD solution focuses on the design of a product or part and CAM solution focuses on how to make it. Designing a CAD model is a first step towards a computer-aided manufacturing. Indeed, CAD solutions provide key functionalities, such as feature based modeling and boundary representation (B-Rep), to reduce the risk of errors and the loss of precision during the manufacturing process handled with a CAM solution. Indeed, a CAD model is intended to be manufactured. Therefore, the 3D modeled object is a virtual twin, also called digital twin, of an object to be manufactured with two objectives:
- checking the correct behavior of the object to be manufactured in a specific environment; and
- ensuring the manufacturability of the object to be manufactured.

PDM stands for Product Data Management. By PDM solution, it is meant any solution, software of hardware, adapted for managing all types of data related to a particular product. A PDM solution may be used by all actors involved in the lifecycle of a product: primarily engineers but also including project managers, finance people, sales people and buyers. A PDM solution is generally based on a product-oriented database. It allows the actors to share consistent data on their products and therefore prevents actors from using divergent data. Such PDM solutions are provided by Dassault Systèmes under the trademark ENOVIA^{®}.

The 3D modeled object outputted by the designing method may be a CAD model, for example comprising or consisting in a feature tree and/or a B-rep. Such a model may stem from a CAE model and may results from a CAE to CAD and 2D block representation conversion process, that the designing method may for example comprise at an initial stage.

The designing method may be included in a production process, which may comprise, after performing the designing method, producing a physical product corresponding to the 3D modeled object by the designing method. The production process may comprise the following steps:
- applying the designing method, thereby obtaining the 3D modeled object (CAD model) outputted by the designing method;
- using the obtained CAD model for manufacturing the part/product.

Using a CAD model for manufacturing designates any real-world action or series of action that is/are involved in/participate to the manufacturing of the product/part represented by the CAD model. Using the CAD model for manufacturing may for example comprise the following steps:
- editing the obtained CAD model;
- performing simulation(s) based on the CAD model or on a corresponding CAE model (e.g. the CAE model from which the CAD model stems, after a CAE to CAD conversion process), such as simulations for validation of mechanical, use and/or manufacturing properties and/or constraints (*e.g.* structural simulations, thermodynamics simulation, aerodynamic simulations);
- editing the CAD model based on the results of the simulation(s);
- optionally (*i.e.* depending on the manufacturing process used, the production of the mechanical product may or may not comprise this step), (*e.g.* automatically) determining a manufacturing specifications/CAM specifications (e.g., stored as a manufacturing file/CAM file or as distributed CAM data stored on one or more storage) based on the (*e.g.* edited) CAD model, for production/manufacturing of the manufacturing product;
- sending the CAD specifications and/or the manufacturing specifications/CAM specifications to a factory; and/or
- (*e.g.* automatically) producing/manufacturing, based on the determined manufacturing specifications/CAM specifications or on the CAD model, the mechanical product originally represented by the model outputted by the designing method. This may include feeding (*e.g.* automatically) the manufacturing specifications/CAM specifications and/or the CAD specifications to the machine(s) performing the manufacturing process.

This last step of production/manufacturing may be referred to as the manufacturing step or production step. This step manufactures/fabricates the part/product based on the CAD model and/or the CAM specifications, *e.g.* upon the CAD model and/or CAD specifications being fed to one or more manufacturing machine(s) or computer system(s) controlling the machine(s). The manufacturing step may comprise performing any known manufacturing process or series of manufacturing processes, for example one or more additive manufacturing steps, one or more cutting steps (e.g. laser cutting or plasma cutting steps), one or more stamping steps, one or more forging steps, one or more bending steps, one or more deep drawing steps, one or more molding steps, one or more machining steps (e.g. milling steps) and/or one or more punching steps. Because the designing method improves the design of a model (CAE or CAD) representing the part/product, the manufacturing and its productivity are also improved.

Editing the CAD model may comprise, by a user *(i.e.* a designer), performing one or more editions of the CAD model, *e.g.* by using a CAD solution. The modifications of the CAD model may include one or more modifications each of a geometry and/or of a parameter of the CAD model. The modifications may include any modification or series of modifications performed on a feature tree of the model (*e.g*. modification of feature parameters and/or specifications) and/or modifications performed on a displayed representation of the CAD model (*e.g*. a B-rep). The modifications are modifications which maintain the technical functionalities of the part/product, *i.e*. the user performs modifications which may affect the geometry and/or parameters of the model but only with the purpose of making the CAD model technically more compliant with the downstream use and/or manufacturing of the part/product. Such modifications may include any modification or series of modification that make the CAD model technically compliant with specifications of the machine(s) used in the downstream manufacturing process. Such modifications may additionally or alternatively include any modification or series of modification that make the CAD model technically compliant with a further use of the product/part once manufactured, such modification or series of modifications being for example based on results of the simulation(s).

The CAM specifications may comprise a manufacturing step up model obtained from the CAD model. The manufacturing step up may comprise all data required for manufacturing the mechanical product so that it has a geometry and/or a distribution of material that corresponds to what is captured by the CAD model, possibly up to manufacturing tolerance errors. Determining the production specifications may comprise applying any CAM (Computer-Aided Manufacturing) or CAD-to-CAM solution for (*e.g*. automatically) determining the production specifications from the CAD model (*e.g*. any automated CAD-to-CAM conversion algorithm). Such CAM or CAD-to-CAM solutions may include one or more of the following software solutions, which enable automatic generation of manufacturing instructions and tool paths for a given manufacturing process based on a CAD model of the product to manufacture:
- Fusion 360,
- FreeCAD,
- CATIA,
- SOLIDWORKS,
   - The NC Shop Floor programmer of Dassault Systèmes illustrated on https://my.3dexperience.3ds.com/welcome/fr/compass-world/rootroles/nc-shop-floor-programmer,
   - The NC Mill-Turn Machine Programmer of Dassault Systèmes illustrated on https://my.3dexperience.3ds.com/welcome/fr/compass-world/rootroles/nc-mill-turn-machine-programmer, and/or
   - The Powder Bed Machine Programmer of Dassault Systèmes illustrated on https://my.3dexperience.3ds.com/welcome/fr/compass-world/rootroles/powder-bed-machine-programmer.

The product/part may be an additive manufacturable part, *i.e.* a part to be manufactured by additive manufacturing (*i.e*. 3D printing). In this case, the production process does not comprise the step of determining the CAM specifications and directly proceeds to the producing/manufacturing step, by directly (*e.g*. and automatically) feeding a 3D printer with the CAD model. 3D printers are configured for, upon being fed with a CAD model representing a mechanical product (*e.g.* and upon launching, by a 3D printer operator, the 3D printing), directly and automatically 3D print the mechanical product in accordance with the CAD model. In other words, the 3D printer receives the CAD model, which is (*e.g*. automatically) fed to it, reads (*e.g.* automatically) the CAD model, and prints (*e.g.* automatically) the part by adding together material, *e.g*. layer by layer, to reproduce the geometry and/or distribution of material captured by the CAD model. The 3D printer adds the material to thereby reproduce exactly in reality the geometry and/or distribution of material captured by the CAD model, up to the resolution of the 3D printer, and optionally with or without tolerance errors and/or manufacturing corrections. The manufacturing may comprise, *e.g.* by a user *(e.g.* an operator of the 3D printer) or automatically (by the 3D printer or a computer system controlling it), determining such manufacturing corrections and/or tolerance errors, for example by modifying the CAD specifications to match specifications of the 3D printer. The production process may additionally or alternatively comprise determining (*e.g.* automatically by the 3D printer or a computer system controlling it) from the CAD model, a printing direction, for example to minimize overhang volume (as described in European patent No. 3327593, which is incorporated herein by reference), a layer-slicing (i.e., determining thickness of each layer, and layer-wise paths/trajectories and other characteristics for the 3D printer head (e.g., for a laser beam, for example the path, speed, intensity/temperature, and other parameters).

The product/part may alternatively be a machined part (*i.e.* a part manufactured by machining), such as a milled part (*i.e.* a part manufactured by milling). In such a case, the production process may comprise a step of determining the CAM specifications. This step may be carried out automatically, by any suitable CAM solution to automatically obtain a CAM specifications from a CAD model of a machined part. The determination of the CAM specifications may comprise (*e.g*. automatically) checking if the CAD model has any geometric particularity (*e.g*. error or artefact) that may affect the production process and (*e.g*. automatically) correcting such particularities. For example, machining or milling based on the CAD model may not be carried out if the CAD model still comprises sharp edges (because the machining or milling tool cannot create sharp edges), and in such a case the determination of the CAM specifications may comprise (*e.g.* automatically) rounding or filleting such sharp edges (*e.g.* with a round or fillet radius that corresponds, *e.g.* substantially equals up to a tolerance error, the radius of the cutting head of the machining tool), so that machining or milling based on the CAD model can be done. More generally, the determination of the CAM specifications may automatically comprise rounding or filleting geometries within the CAD model that are incompatible with the radius of the machining or milling tool, to enable machining/milling. This check and possible corrections (*e.g.* rounding or filleting of geometries) may be carried out automatically as previously discussed, but also, by a user (*e.g*. a machining engineer), which performs the correction by hand on a CAD and/or CAM solution, *e.g*. the solution constraining the user to perform corrections that make the CAD model compliant with specifications of the tool used in the machining process.

Further to the check, the determination of the CAM specifications may comprise (*e.g.* automatically) determining the machining or milling path, *i.e.* the path to be taken by the machining tool to machine the product. The path may comprise a set of coordinates and/or a parameterized trajectory to be followed by the machining tool for machining, and determining the path may comprise (*e.g*. automatically) computing these coordinates and/or trajectory based on the CAD model. This computation may be based on the computation of a boundary of a Minkowski subtraction of the CAD model by a CAD model representation of the machining tool, as for example discussed in European Patent Application EP21306754.9 filed on 13 December 2021 by Dassault Systèmes, and which is incorporated herein by reference. It is to be understood that the path may be a single path, *e.g*. that the tool continuously follows without breaking contact with the material to be cut. Alternatively, the path may be a concatenation of a sequence sub-paths to be followed in a certain order by the tool, *e.g*. each being continuously followed by the tool without breaking contact with the material to be cut. Optionally, the determination of the CAM specifications may then comprise (*e.g*. automatically) setting machine parameters, including cutting speed, cut/pierce height, and/or mold opening stroke, for example based on the determined path and on the specification of the machine. Optionally, the determination of the CAM specifications may then comprise (*e.g*. automatically) configuring nesting where the CAM solution decides the best orientation for a part to maximize machining efficiency.

In this case of a machining or milling part, the determining of the CAM specifications thus results in, and outputs, the CAM specifications comprising a machining path, and optionally the set machine parameters and/or specifications of the configured nesting. This outputted CAM specifications may be then (*e.g*. directly and automatically) fed to the machining tool and/or the machining tool may then (*e.g.* directly and automatically) be programmed by reading the specifications, upon which the production process comprises the producing/manufacturing step where the machine performs the machining of the product according to the production specifications, *e.g.* by directly and automatically executing the production specifications. The machining process comprises the machining tool cutting a real-world block of material to reproduce the geometry and/or distribution of material captured by the CAD model, *e.g.* up to a tolerance error (*e.g.* tens of microns for milling).

The product/part may alternatively be a molded part, *i.e.* a part manufactured by molding (*e.g*. injection-molding). In such a case, the production process may comprise the step of determining the CAM specifications. This step may be carried out automatically, by any suitable CAM solution to automatically obtain a CAM specifications from a CAD model of a molded part. The determining of the CAM specifications may comprise (*e.g*. automatically) performing a sequence of molding checks based on the CAD model to check that the geometry and/or distribution of material captured by the CAD model is adapted for molding, and (*e.g*. automatically) performing the appropriate corrections if the CAD model is not adapted for molding. Performing the checks and the appropriate corrections (if any) may be carried out automatically, or, alternatively, by a user (*e.g*. a molding engineer), for example using a CAD and/or CAM solution that allows a user to perform the appropriate corrections on the CAD model but constraints him/her corrections that make the CAD model compliant with specifications of the molding tool(s). The checks may include: verifying that the virtual product as represented by the CAD model is consistent with the dimensions of the mold and/or verifying that the CAD model comprises all the draft angles required for demolding the product, as known *per se* from molding. The determining of the CAM specifications may then further comprise determining, based on the CAD model, a quantity of liquid material to be used for molding, and/or a time to let the liquid material harden/set inside the mold, and outputting CAM specifications comprising these parameters. The production process then comprises (*e.g*. automatically) performing the molding based on the outputted specifications, where the mold shapes, for the determined hardening time, a liquid material into a shape that corresponds to the geometry and/or distribution of material captured by the CAD model, *e.g.* up to a tolerance error (*e.g.* up to the incorporation of draft angles or to the modification of draft angles, for demolding).

The product/part may alternatively be a stamped part, also possibly referred to as "stamping part", *i.e.* a part to be manufactured in a stamping process. The production process may in this case comprise (*e.g.* automatically) determining a CAM specifications based on the CAD model. The CAD model represents the stamping part, *e.g*. possible with one or more flanges if the part is to comprise some, and possibly in this latter case with extra material to be removed so as to form an unfolded state of one or more flanges of the part, as known *per se* from stamping. The CAD model thus comprises a portion that represents the part without the flanges (which is the whole part in some cases) and possibly an outer extra patch portion that represents the flanges (if any), with possibly the extra material (if any). This extra patch portion may present a g2-continuity over a certain length and then a g1-continuity over a certain length.

The determination of the CAM specifications may in this stamping case comprise (*e.g*. automatically) determining parameters of the stamping machine, for example a size of a stamping die or punch and/or a stamping force, based on the geometry and/or distribution of material of the virtual product as captured by the CAD model. If the CAD model also comprises the representation of the extra material to be removed so as to form an unfolded state of one or more flanges of the part, the extra material to be removed may for example be cut by machining, and determining the CAM specifications may also comprise determining a corresponding machining CAM specifications, *e.g.* as discussed previously. If there are one or more flanges, determining the CAM specifications may comprise determining geometrical specifications of the g2-continuity and g1-continuity portions that allow, after the stamping itself and the removal of the extra material, to fold in a folding process the flanges towards an inner surface of the stamped part and along the g2-continuity length. The CAM specifications thereby determined may thus comprise: parameters of the stamping tool, optionally said specifications for folding the flanges (if any), and optionally a machining production specifications for removing the extra material (if any).

The stamping production process may then output, *e.g*. directly and automatically, the CAM specifications, and perform the stamping process (*e.g*. automatically) based on the specifications. The stamping process may comprise stamping (*e.g*. punching) a portion of material to form the product as represented by the CAD specifications, that is possibly with the unfolded flanges and the extra material (if any). Where appropriate, the stamping process may then comprise cutting the extra material based on the machining production specifications and folding the flanges based on said specifications for folding the flanges, thereby folding the flanges on their g2-continuity length and giving a smooth aspect to the outer boundary of the part. In this latter case, the shape of the part once manufactured differ from its virtual counterpart as represented by the CAD model in that the extra material is removed and the flanges are folded, whereas the CAD model represents the part with the extra material and the flanges in an unfolded state.

The computer system may comprise a processor coupled to a memory and a graphical user interface (GUI), the memory having recorded thereon a computer program comprising instructions for performing the training and/or designing method. The memory may also store a database. The memory is any hardware adapted for such storage, possibly comprising several physical distinct parts (e.g. one for the program, and possibly one for the database).

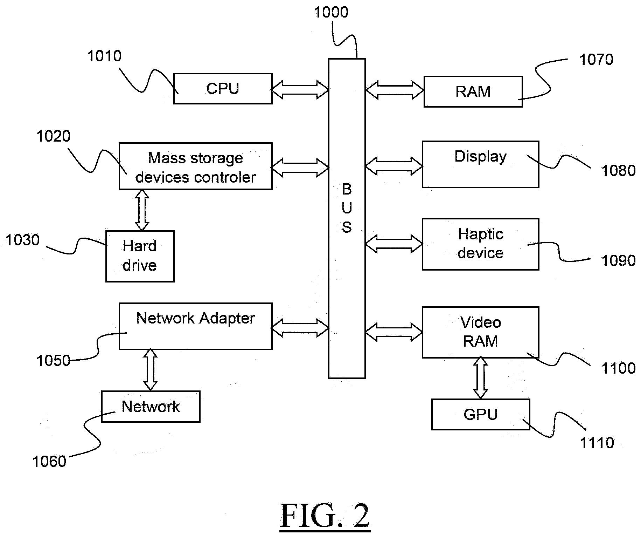

FIG. 2 shows an example of the system, wherein the system is a client computer system, *e.g*. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the designing method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

An implementation is now discussed with reference to FIG.s 3-25.

The implementation offers a solution of suggestions of functions in an application of which particularity is to represent connections of operators in a form alike a graph, the 2D block representation. An example of such application is xGenerative Design, which is part of the CATIA portfolio and is a web application combining 3D and visual scripting modeling based on a 2D block representation. The solution may however be adapted to suggest functions in a feature-tree-based application such as the feature-tree-based CATIA.

FIG. 3 shows a screenshot of the interface of such a 2D block programming application.

Such an application can display simultaneously a 3D shape representation 300 of a 3D modeled object representing a manufacturing product (e.g., a folded alveolar sheet structure here), and a 2D block representation 310 of the 3D modeled objection. The 2D block representation 310 comprises block nodes 320 which may optionally be rectangles all parallel to the screen, input connectors 322 which may be dot shapes displayed on a left boundary side of a respective block node 320, output connectors 324 which may be dot shapes displayed on a right boundary side of a respective block node 320, and arcs 326 each connecting an output connector 324 of a first block node to one or more input connectors 322 each of another second block node 320. The application can also display menus and menu buttons 330 and widgets 340.

The application allows generative 3D modeling via a library or predetermined set of operators that may be instantiated. The operators are configured to handle geometrical operations (Point, Line, Curve, Surface, Extrude, Rotate, Mesh, etc.), mathematical ones (addition, division, etc.), list management, and so on.

The library may propose 500+ operators, and it may be growing. As a result, finding the appropriate operator at a specific design stage might be challenging to the user. The proposed solution tackles the issue of discoverability.

Referring to FIG. 4, an operator is a node in the virtual graph. The figure shows an instance of a point-by-coordinates node. On the left part of the figure, the node is not selected by the user, such that only its input connectors 322 and its output connector 324 are visible to the user. On the right part of the figure, the node has been selected, such that additional data fields 400, menus 410, and information 420 are displayed to the user. The right part of the figure shows the view of a node when it has been selected by the user (through a mouse click for instance) to allow the modification of the input values, the management of the node status, etc. An operator processes input data and provides output results through internal operations (geometrical transformations, mathematical equations, data structure management, etc.). In the example of FIG. 4, the "Point By Coordinates" operator/node takes three lengths as coordinates and, from them, builds a geometrical point (named "Point.1" here).

Referring to FIG. 5, nodes can be connected via arcs 326 through input and output connectors, thus forming the virtual graph. The figure indeed shows how the "pt" input connector of a "coordinates" block node is connected to the output of the Point by Coordinates operator. In this simple example, the user has connected the previous point to a "Coordinates" node to get the point coordinates. The "coordinates" forms an example of an operator with several outputs.

Referring to FIG. 6, the application may finely manage data types: the data in input connectors and transiting/flowing between nodes are typed to define their nature and ensure compatibilities (compliancy) between output and input connectors. The figure shows an example of a "line from two points" operator, thanks to which the user has generated a line using two points (line segment). To be able to do this, each input connector has a specific static object type to specify which kind of data can be connected thereto:
- pt1 and pt2 are of type *"GeometricPoint",* expecting geometrical points;
- st and end are optional extension lengths of the Line, beyond the two points; they are of type *"Length";*
- sup is an optional surface support for the Line, on which it can be drawn. It is of type *"GeometricSurface".*

Referring to FIG. 7, if a connection is incorrect regarding types, the node can be in an error state, and a visual alert can be displayed to the user. In this example, a Length is connected as the second point of the Line. The types "Length" and "GeometricPoint" being incompatible, the node is at "Error", and generation of the Line is not possible.

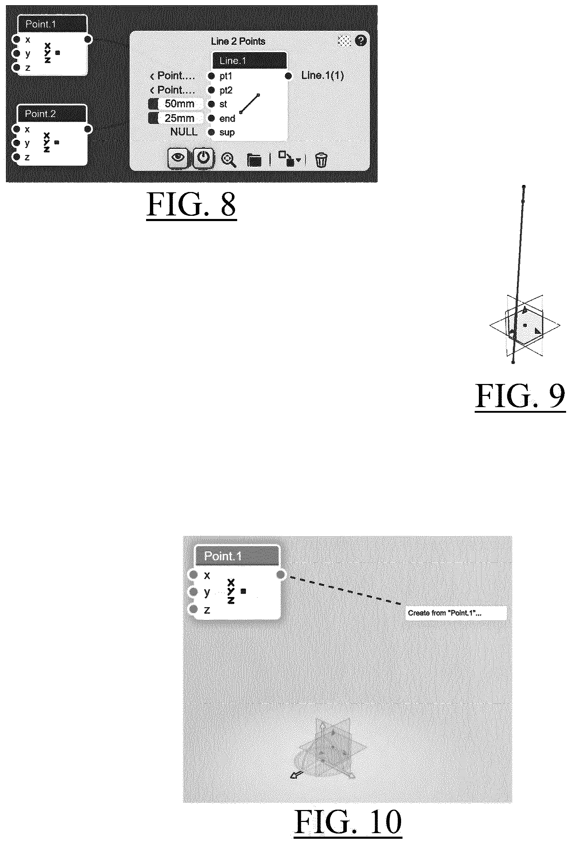

FIG.s 8-9 show an example of a generated Line with two points and two extension lengths, including the 2D block representation (or graph view) on FIG. 8, and the 3D shape representation (or 3D view) on FIG. 9.

Referring to FIG. 10, in the prior art, a user can select one node and by pressing Space, a search menu is displayed for further connection. Here the node "Point.1" is selected. The disclosure tackles the issue of the application proposing to the user a set of appropriate operators to connect the selection to. Without any intelligent treatment, the number of suggestions might be difficult to compute, while keeping the application responsive.

In such a context where many operators exist, the proposed solution and its implementation offer a way to help users find the operator they are looking for as quickly as possible, choose the right function to use in a defined situation in the application, do so in the most optimized and efficient way possible using artificial intelligence (e.g., deep learning) and a dataset corresponding to previously performed choices (e.g., by the user and/or by other users).

From a user selection, in a user designed 2D block representation, the proposed solution and its implementation allow to propose an appropriate ranked list of operator suggestions based on Machine Learning/Deep Learning methods and on relational tree probabilities represented by the dataset. Operators allow to manipulate any type of data (geometric, mathematical, image, etc.) via mathematical functions transforming inputs into outputs. In the implementation, these data are taken into account to make these suggestions. This improves operator discoverability and ease of access.

Therefore, this implementation provides suggestions based on what a Deep Learning Model saw during its training on different graph operators examples, and on the dataset that may represent previous choices by the user. This allows the proposal of suggestions that take into account user experience in previous operator creation in 2D block representations, and this helps increasing the accuracy of these suggestions. Moreover the role of the Deep Learning Model and the dataset are complementary: the Deep Learning Model allows the users to discover set of operators and guide them during the design. The dataset, on the other hand, represents the frequency of use of the operators and adapts over time to the choices of the user. Thus, the use of the dataset allows outputting predictions specifically tailored to the user. For example, a beginner user may be guided by the Deep Learning Models and the dataset based on a plurality of "default" previously performed designs, predicting the most popular operators used. An intermediate user may discover over time the strength of the customization of the designing method. The dataset may adapt with the behavior of expert users, thereby being able to predict the specific design habits of each of the expert users. Thereby the designing method may be beneficial to all users, giving generic, popular choices in absence of specific personalization and tailoring the result over time to the user behavior.

Notably, the training of Deep Learning Models may require a step of data normalization, to obtain optimal performances of the models. The dataset may keep track of the loss information during the normalization, by highlighting the most common operators.

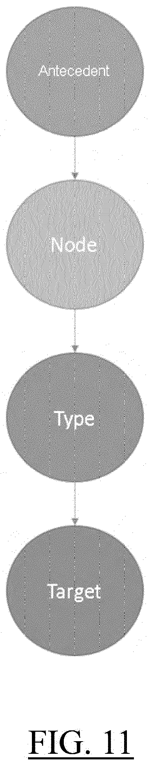

Referring to FIG. 11, the designing method and the implementation may be based on the concept of relational tree probability. A relational tree probability may be a tree with dedicated nodes: an antecedent node (e.g., a second operator), a node (e.g., a first operator), a type (e.g., an object type), a target (e.g., a third operator). The tree may comprise a link from the antecedent node to the node, from the node to the type, and from the type to the target. Such link may indicate the relationship between the first, second, and third operator and the object type. Each level of the tree may have its own role. For example, the antecedent node and the type may allow a semantic approach. The node may indicate the working node.

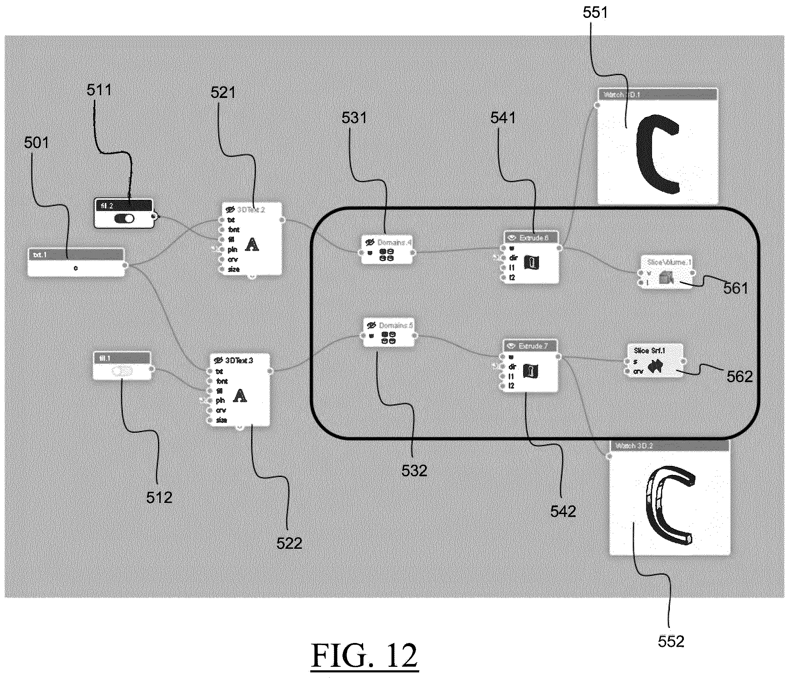

FIG. 12 illustrates an example of 2D block representation.

A node 501 outputs the letter "c". The node 501 is an input of both nodes 521 and 522. The nodes 521 and 522 transform the letter "c" obtained as input into a 3D letter. Node 521 has as input a modifier 511 telling that the "fill" option is active, whereas the node 522 has as input a modifier 512 telling that the "fill" option is not active. Therefore, the object types of the output of the nodes 521 and 522 are different. Specifically, the output of node 521 is a filled, 3D, geometrical object and the output of node 522 is a 2D geometrical object. The outputs of nodes 521 and 522 are connected to "Domain" operators 531 and 532 respectively. The outputs of nodes 531 and 532 are connected to "Extrude" operators 541 and 542 respectively. Thus, both block nodes 541 and 542 represent the same operator and are connected to a same input operator "Domain". However, their inputs have different object type, being "Geometric Volume" in the case of block node 541 and "Geometric Surface" in the case of block node 542. The outputs may be visualized in the block nodes 551 and 552 respectively. The outputs of the block nodes 541 and 542 may be connected to different operators, for example to the operator "Slice Volume" 561 for block node 541 and to the operator "Slice Surface" 562 for block node 542.

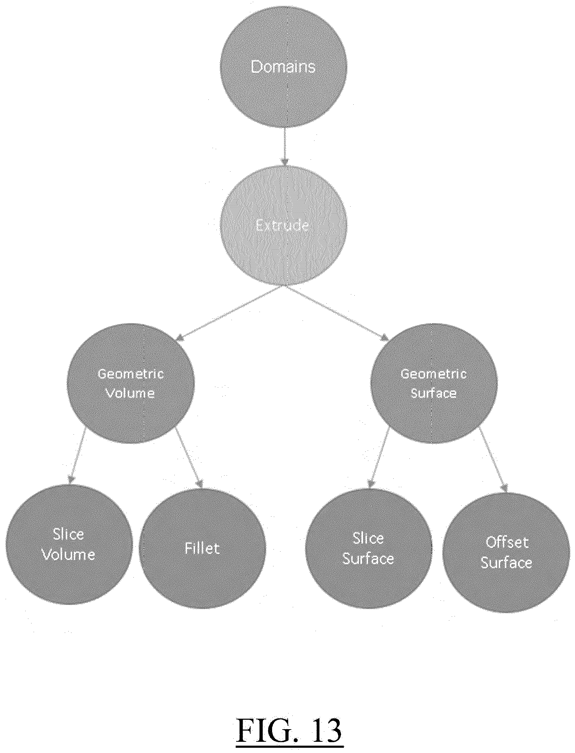

FIG. 13 represents a tree of possible choices of operators and object types illustrated in FIG. 12 and corresponding to the relational tree probability. Specifically, a "Domain" operator (e.g., the antecedent node of FIG. 11) may be connected to "Extrude" operators (e.g., the node of FIG. 11) which may may be connected, depending on the object type received as input, to objects types (e.g., the type of FIG. 11) "Geometric Volume" or "Geometric Surface". The object type "Geometric Volume" may be connected to the operators (e.g., the target of FIG. 11) "Slice Volume" or "Fillet". The object type "Geometric Surface" may be connected to the operators (e.g., the target of FIG. 11) "Slice Surface" or "Offset Surface".

FIG.s 14-20 provide screenshots and illustrations demonstrating the implementation of the generating method and showing how the dataset obtained at S25 may be updated in real time as the user designs an object.

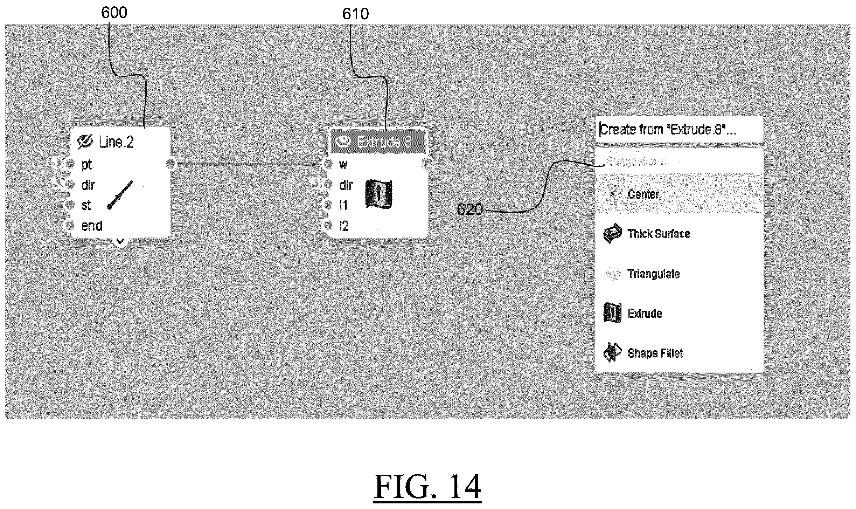

FIG. 14 illustrates an example of a portion of a 2D block representation. The output of a node 600 representing the operator "Line.2" is connected to a block 610 representing the operator "Extrude.8". The user selected (at S20) the output connector of the operator 610. A graphical representation 620 of five operator is displayed.

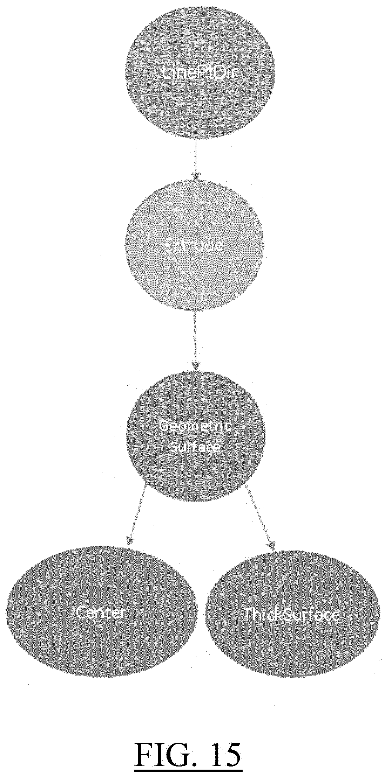

FIG. 15 illustrates the relational tree. The antecedent node is an operator "LinePtDir", the node is the operator "Extrude", and the type is "Geometric Surface". The relation tree further comprises leaves corresponding to each of the possible options (e.g., displayed at S50). In FIG. 15, two possibles options are illustrated, "Center" and "ThickSurface", corresponding to the top two predicted options of the suggestions 620 of FIG 14.

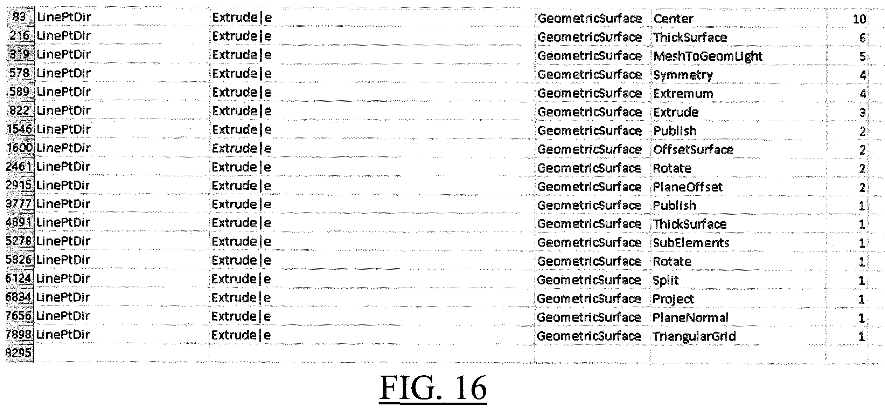

FIG. 16 illustrates a portion of the dataset obtained at S25. The portion comprises rows, each row comprising a tuple and a weight. Each of the tuples has as second operator "LinePtDir", as first operator ""Extrude", and as type "GeometricSurface". The target operator of the tuples varies as well as the relative weights, corresponding to the different instantiations of the tuples in the previous designs.

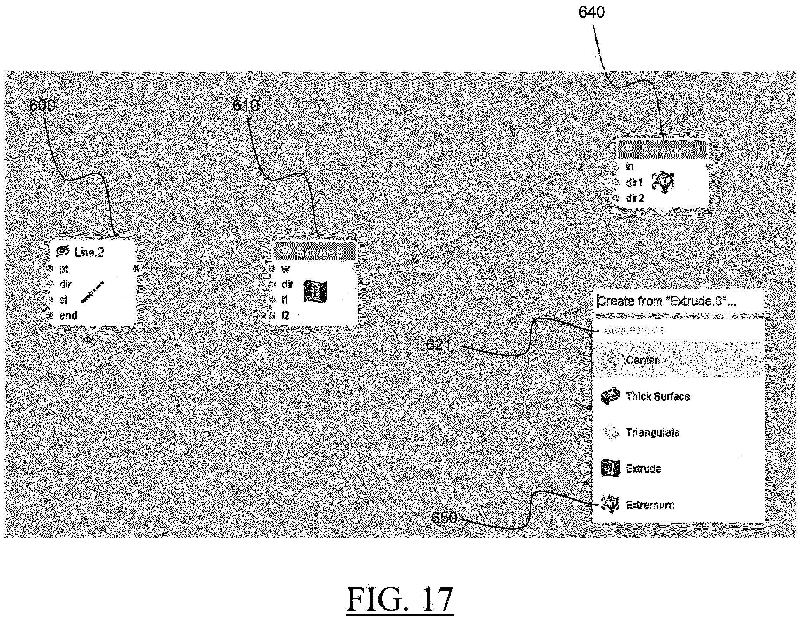

FIG. 17 illustrates the effect of a first selection by the user. The user selected as option in the graphical representation 620 an operator "Extremum". Such operator was not in the top 5, and hence not displayed. Thus, a new node 640 representing the operator "Extremum.1" is created and connected to the node 610. The dataset is updated accordingly. For example, the weight in the row illustrated in FIG. 16 having as target operator "Extremum" may be increased from 4 to 5. When the user selects again the output connector of the node 610, again a graphical representation 621 of five operators is displayed. The graphical representation 621 comprises an identification 650 of the operator "Extremum". The fact that the operator "Extremum" is visible at 621 but not 620 reflects the increase of the weight of the relative tuple, showing the efficacy of the designing method and of the implementation.

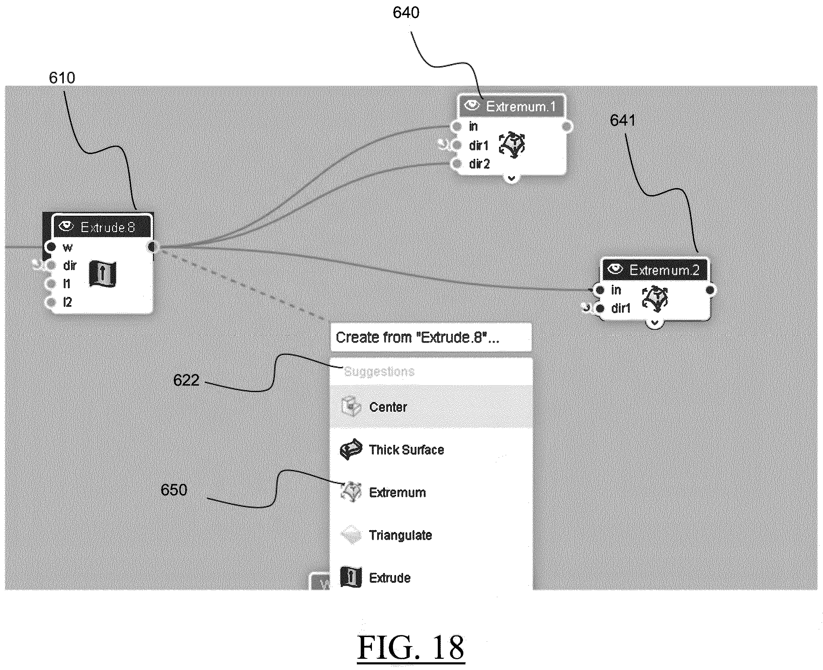

FIG. 18 illustrates the effect of the user selecting again the operator "Extremum" as an option. A new node 641 representing the operator "Extremum.2" is created. The dataset is updated accordingly, e.g., the weight in the row illustrated in FIG. 16 having as target operator "Extremum" may be increased from 5 to 6. When the user selects again the output connector of the node 610, again a graphical representation 622 of five operators is displayed. The graphical representation 622 comprises an identification 650 of the operator "Extremum". The fact that the identification of the operator "Extremum" is higher in the graphical representation at 622 compared to 621 reflects the increase of the weight of the relative tuple, further showing the efficacy of the designing method and of the implementation.

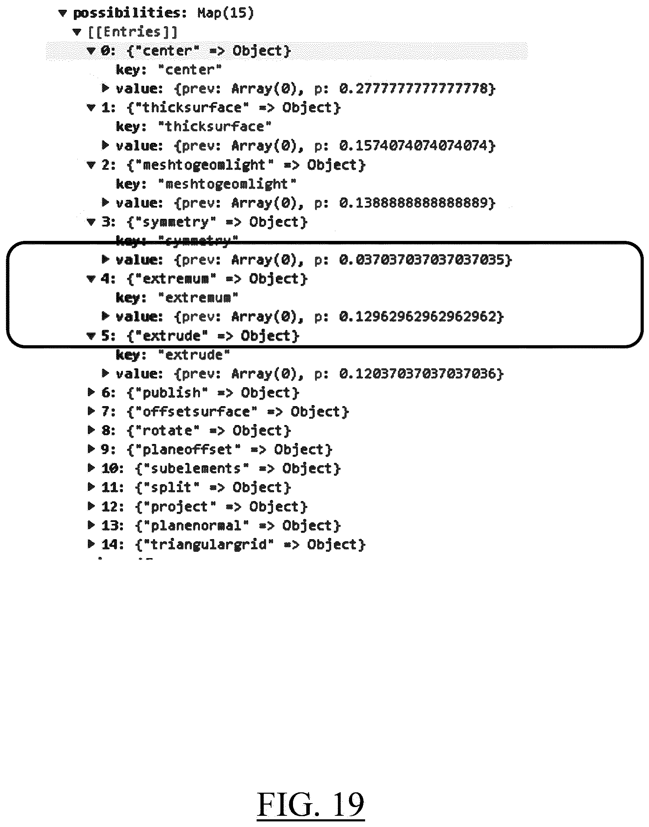

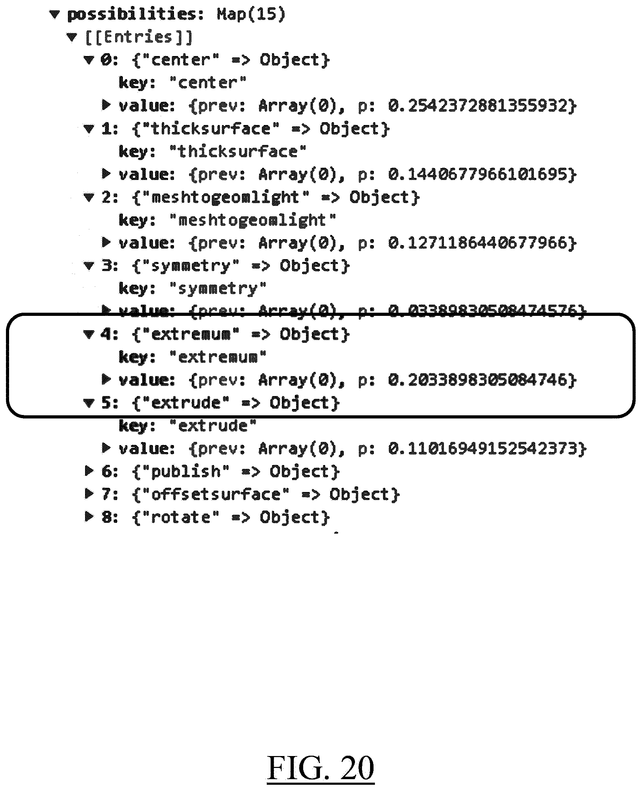

FIG.s 19-20 illustrate how the code behind the graphical representation is updated. In FIG. 19 the operator "Extremum" is at position 4 and has a score (e.g., the third score) of approximately 0.13. After the user selects a number of times the operator "Extremum", the weight of the relative tuple increases, increasing the score (e.g., the third score). The effect is visible in FIG. 20, wherein the operator "Extremum" has a weight of approximately 0.20.

After several designs, the dataset comprises several pieces of data, each reflecting the choices of the user. Thereby, the dataset may become larger and uniquely reflecting the user's choices and preferences.

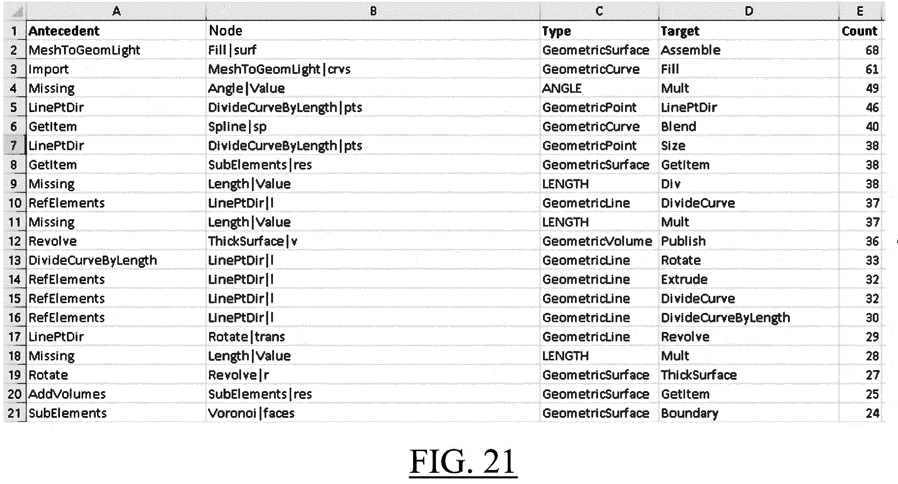

FIG. 21 illustrates an examples of a dataset that may be obtained at S25. Each row in FIG. 21 corresponds to a piece of data of the dataset, comprising a tuple and a weight (called count in FIG. 21). The first column, the "Antecedent" column corresponds to the second operator of the tuples. The second column, the "Node" column, corresponds to the first operator of the tuples. The third column, the "Type" column, corresponds to the object type of the tuples. The fourth column, the "Target" column, corresponds to the third operator of the tuples.

In the implementation, the obtained neural network may be a multi-layer perceptron.

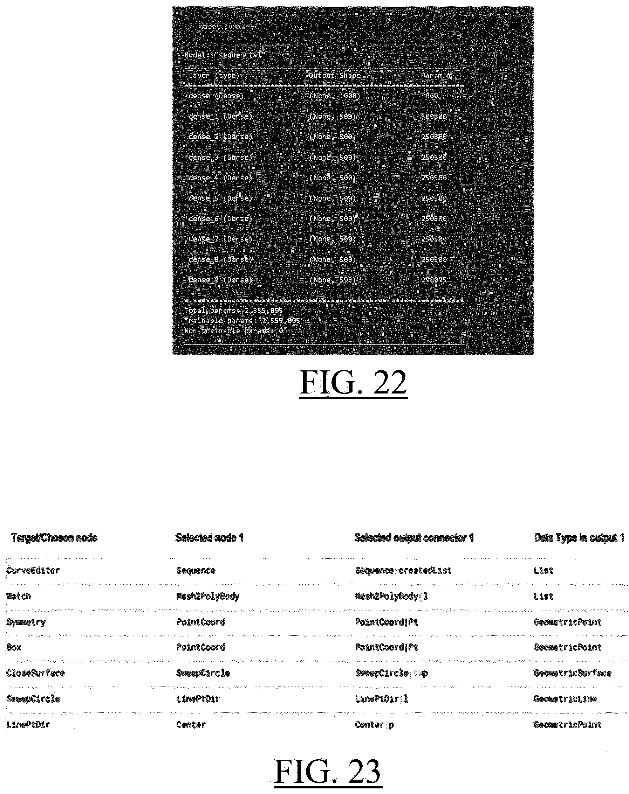

Referring to FIG. 22, the neural network model (the Deep Learning Model) may be a multi-layer-perceptron having the architecture represented on the figure.the implemented, the neural network model was trained based on a training dataset built using 3D Designs already completed (e.g., with CATIA xGenerative Design).

FIG. 23 shows a training dataset extract thus obtained, where each line corresponds to a training pattern. On the leftmost column, the figure shows the target/chosen node (i.e., ground truth operator, that is, prediction output), in other words the result that the Al model has to aim at. The other columns stand for the prediction input data as described in previous section, simulating a selection from the user: for instance, the first line a mono selection of a "Sequence" node (creating a sequence of numbers) having the output called "createdList" containing a List of elements. For this situation, the user has chosen/connected the node CurveEditor.

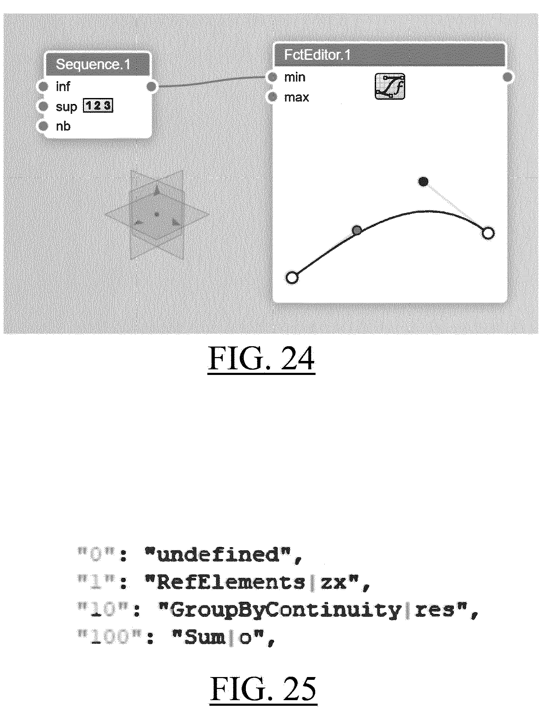

FIG. 24 shows an example of a 2D block representation portion that may correspond to said first line.

Training datasets retrieved from existing designs may be heterogeneous in terms of number of examples, and this may impact the accuracy of the prediction due to biased training. In a test of the implementation, more than one hundred examples were obtained for one class, while less than five examples were obtained for another class. Ideally, the training should have the same number of examples for each class. Considering this, a data normalization may consist in aiming for a fixed number of initial examples (e.g., 40) by class, and discard examples in classes initially having more than this fixed number of examples, and duplicate examples in classes having less than this fixed number of examples so as to reach the target.

Neural networks may take scalar values (numbers) as input data. Thus, the dataset creation may comprise converting the data in a compatible format for the models. This may be performed via indexing. In separate indexes, the dataset creation may associate operators and connectors (inputs and outputs) to numbers, passed to the Al models.

FIG. 25 shows an extract of the indexing of output connectors of operators, with the index on the left column, and the operator/connector name on the right column. For example, the output "zx" of the operator "RefElements" (giving the canonical planes -xy, yz, zx- and origin -O- of the 3D space) has an index of 1. "1" is given to the Al models, standing for "RefElements | zx".

When the Designs are processed, indexes generated, etc., the training of the model can start. The training may provide it with input data and observe the outputted prediction. Afterwards, the training may compare this prediction with the desired result related to this input, and use gradient descent and the softmax function to modify the weights of the Deep Learning model to converge to a final correct result.

An API may integrate the model into the application, by extracting the information of the user selection, using it to make a prediction, and finally, showing the predicted suggestions to the user.

## Claims

1. A computer-implemented method for designing a 3D modeled object representing a product to be manufactured, the designing method comprising:
- by a computer system, displaying (S10) simultaneously:
▪ a 3D shape representation of the 3D modeled object, and
▪ a 2D block representation of the 3D modeled object, the 2D block representation comprising:
∘ block nodes, where:
each block node represents a respective operator among a predetermined set of operators, each operator of the predetermined set of operators having a respective data identifier, each operator of the predetermined set of operators further having one or more inputs and an output, each input of each operator having a respective data identifier and the output of each operator having a respective data identifier, and for at least one block node, the output of the respective operator represented by the at least one block node is a respective set of one or more geometrical objects, and:
• the output of the operator has a dynamic object cardinality, at least one input of the operator having a dynamic object cardinality, and
• the output of the operator has an object type, where optionally the object type of the output of the operator is dynamic, in which case at least one input of the respective operator has a dynamic object type,
∘ one or more input connectors and an output connector on each respective block node, where:
each input connector represents a respective input of the respective operator represented by the respective block node, and
the output connector represents the output of the respective operator represented by the respective block node, and
o arcs each between the output connector of a first block node and a respective input connector of a second block node, where:
each arc represents data flow from the output connector of the first block node to the respective input connector of the second block node,
the 2D block representation being configured such that an execution of the data flow represented by the arcs of the 2D block representation outputs the 3D shape representation;
- by a user interacting graphically with the 2D block representation, performing (S20) a selection, among the at least one block node, of one output connector, the block node of the selected output connector having an antecedent block node;
- by the computer system:
▪ obtaining a pre-trained machine-learning function;
▪ obtaining (S25) a dataset including pieces of data, the dataset being based on a plurality of previously performed designs, each piece of data comprising a tuple and a weight,
the tuple comprising:
∘ a first operator represented by a first block node in a design of the plurality of previously performed designs,
∘ a second operator represented by a second block node in the design, the second block node having an output connector connected to the first block node,
∘ a third operator represented by a third block node having a respective input connector connected to a respective output connector of the first block node, and
∘ the object type of the respective output connector of the first block node,
the weight depending on an extent of instantiation of the tuple in the plurality of previously performed designs;
▪ providing (S30) to the machine-learning function input data including at least:
∘ the data identifier of the respective operator represented by the block node of the selected output connector,
∘ the data identifier of the selected output connector, and
o an object type of the selected output connector,
▪ outputting (S40), based on a result of the machine-learning function and on the dataset, a prediction of one or more operators among the predetermined set of operators;
- by the computer system, displaying (S50) a graphical representation of at least one operator of the prediction;
- by the user, selecting (S60) an operator among the at least one operator of the prediction;
- by the computer system,
▪ adding (S70) to the 2D block representation a block node representing the selected operator; and
▪ updating (S80) the display of the 2D block representation, at least by displaying the added block node;
- adding (S90) to the 2D block representation an arc between the selected output connector and a respective connector of the added block node, thereby obtaining an updated 2D block representation;
- updating (S100) the display of the 2D block representation, at least by displaying the added arc; and
- executing (S110) the data flow represented by the arcs of the updated 2D block representation, thereby outputting an updated 3D shape representation; and
- displaying (S120) the updated 3D shape representation.

2. The designing method of claim 1, wherein the outputting, based on the machine-learning function and the dataset, of a prediction of one or more operators comprises:
- obtaining as a result of the machine-learning function a first score of each given operator of the predetermined set of operators;
- determining a second score of each given operator of the predetermined set of operators, the second score of the given operator representing a frequency of a respective tuple in the dataset for which:
▪ the first operator of the respective tuple is the respective operator represented by the block node of the selected output connector,
▪ the second operator of the respective tuple is the respective operator represented by the antecedent block node of the block node of the selected output connector,
▪ the third operator of the respective tuple is the given operator,
▪ the object type of the respective tuple is the object type of the selected output connector; and
- combining the first and second score, thereby obtaining a third score of each operator of the predetermined set of operators.

3. The designing method of claim 2, wherein the frequency of a respective tuple represented by the second score is a frequency of the respective tuple among all tuples of the dataset having the same first operator, second operator, and object type as the respective tuple.

4. The designing method of any one of claims 3, wherein the second score Score₂(*Oᵢ*) of an operator *Oᵢ* is given by the formula: ${Score}_{2} \left({O}_{i}\right) = \frac{{w}_{i}}{{\sum }_{j} {w}_{j}}$ where {*Oⱼ*}*_{ⱼ}*. is a set of operators comprising the operator *Oᵢ* and comprised in the predetermined set of operators, each operator *Oⱼ* being the third operator of a tuple of which first operator, second operator, and object type are the same as those of the respective tuple of *Oᵢ*, and where *wⱼ* is a weight of the tuple having as third operator *Oⱼ*.

5. The designing method of any one of claims 2 to 4, wherein the third score of each operator of the predetermined set of operator is a convex combination of the first and the second score of the operator.

6. The designing method of claim 5, wherein the third score Score₃(*O*) of an operator *O* of the predetermined set of operators is given by the formula: ${Score}_{3} \left(O\right) = \frac{c ⋅ {Score}_{1} \left(O\right) + c ′ ⋅ {Score}_{2} \left(O\right)}{c + c ′}$ where:
- c and c' are numerical coefficients,
- Score₁(*O*) is the first score of the operator*O*, and
- Score₂(*O*) is the second score of the operator*O*.

7. The designing method of any one of claims 1 to 6, wherein the designing method further comprises, after the selecting, by the user, of an operator among the at least one operator of the prediction, increasing by a predetermined number the weight of a respective tuple of the dataset for which:
- the first operator of the respective tuple is the respective operator represented by the block node of the selected output connector,
- the second operator of the respective tuple is the respective operator represented by the antecedent block node of the block node of the selected output connector,
- the third operator of the respective tuple is the selected operator, and
- the object type of the respective tuple is the object type of the selected output connector.

8. The designing method of any one of claim 1 to 7, wherein the input data of the machine-learning function further comprise a value depending on an object cardinality of the selected output connector.

9. The designing method of claim 8, wherein the value depending on the object cardinality of the selected output connector is a binary value indicative of whether the cardinality is 1 or higher than 1.

10. The designing method of any one of claims 1 to 9, wherein the machine-learning function is a multilayer perceptron.

11. A computer program comprising instructions which, when executed by a processor, cause the processor to perform the designing method according to any one of claim 1 to 10.

12. A computer-readable storage medium having recorded thereon the computer program of claim 11.

13. A system comprising a processor coupled to a memory, the memory having recorded thereon the computer program of claim 11.

## Amended claims

### Amended claims in accordance with Rule 137(2) EPC.

1. A computer-implemented method for designing a 3D modeled object to be fed to an automatic manufacturing process and representing a product to be manufactured, the designing method comprising:
- by a computer system, displaying (S10) simultaneously:
▪ a 3D shape representation of the 3D modeled object, and
▪ a 2D block representation of the 3D modeled object, the 2D block representation comprising:
o block nodes, where:
each block node represents a respective operator among a predetermined set of operators, each operator of the predetermined set of operators having a respective data identifier, each operator of the predetermined set of operators further having one or more inputs and an output, each input of each operator having a respective data identifier and the output of each operator having a respective data identifier, and for at least one block node, the output of the respective operator represented by the at least one block node is a respective set of one or more geometrical objects, and:
• the output of the operator has a dynamic object cardinality, at least one input of the operator having a dynamic object cardinality, and
• the output of the operator has an object type, where optionally the object type of the output of the operator is dynamic, in which case at least one input of the respective operator has a dynamic object type,
∘ one or more input connectors and an output connector on each respective block node, where:
each input connector represents a respective input of the respective operator represented by the respective block node, and
the output connector represents the output of the respective operator represented by the respective block node, and
o arcs each between the output connector of a first block node and a respective input connector of a second block node, where:
each arc represents data flow from the output connector of the first block node to the respective input connector of the second block node,
the 2D block representation being configured such that an execution of the data flow represented by the arcs of the 2D block representation outputs the 3D shape representation;
- by a user interacting graphically with the 2D block representation, performing (S20) a selection, among the at least one block node, of one output connector, the block node of the selected output connector having an antecedent block node;
- by the computer system:
▪ obtaining a pre-trained machine-learning function;
▪ obtaining (S25) a dataset including pieces of data, the dataset being based on a plurality of previously performed designs, each piece of data comprising a tuple and a weight,
the tuple comprising:
o a first operator represented by a first block node in a design of the plurality of previously performed designs,
o a second operator represented by a second block node in the design, the second block node having an output connector connected to the first block node,
o a third operator represented by a third block node having a respective input connector connected to a respective output connector of the first block node, and
o the object type of the respective output connector of the first block node,
the weight depending on an extent of instantiation of the tuple in the plurality of previously performed designs;
▪ providing (S30) to the machine-learning function input data including at least:
o the data identifier of the respective operator represented by the block node of the selected output connector,
o the data identifier of the selected output connector, and
o an object type of the selected output connector,
▪ outputting (S40), based on a result of the machine-learning function and on the dataset, a prediction of one or more operators among the predetermined set of operators, the outputting comprising:
∘ obtaining as a result of the machine-learning function a first score of each given operator of the predetermined set of operators;
o determining a second score of each given operator of the predetermined set of operators, the second score of the given operator representing a frequency of a respective tuple in the dataset for which:
• the first operator of the respective tuple is the respective operator represented by the block node of the selected output connector,
• the second operator of the respective tuple is the respective operator represented by the antecedent block node of the block node of the selected output connector,
• the third operator of the respective tuple is the given operator,
• the object type of the respective tuple is the object type of the selected output connector; and
o combining the first and second score, thereby obtaining a third score of each operator of the predetermined set of operators;
the predicted one or more operators being based on a ranking of the third scores;
- by the computer system, displaying (S50) a graphical representation of at least one operator of the prediction;
- by the user, selecting (S60) an operator among the at least one operator of the prediction;
- by the computer system,
▪ adding (S70) to the 2D block representation a block node representing the selected operator; and
▪ updating (S80) the display of the 2D block representation, at least by displaying the added block node;
- adding (S90) to the 2D block representation an arc between the selected output connector and a respective connector of the added block node, thereby obtaining an updated 2D block representation;
- updating (S100) the display of the 2D block representation, at least by displaying the added arc; and
- executing (S110) the data flow represented by the arcs of the updated 2D block representation, thereby outputting an updated 3D shape representation; and
- displaying (S120) the updated 3D shape representation.

2. The designing method of claim 1, wherein the frequency of a respective tuple represented by the second score is a frequency of the respective tuple among all tuples of the dataset having the same first operator, second operator, and object type as the respective tuple.

3. The designing method of claim 2, wherein the second score Score₂(*Oᵢ*) of an operator *Oᵢ* is given by the formula: ${Score}_{2} \left({O}_{i}\right) = \frac{{w}_{i}}{{\sum }_{j} {w}_{j}}$ where {*Oⱼ*}*ⱼ* is a set of operators comprising the operator *Oᵢ* and comprised in the predetermined set of operators, each operator *Oⱼ* being the third operator of a tuple of which first operator, second operator, and object type are the same as those of the respective tuple of *Oᵢ*, and where *wⱼ* is a weight of the tuple having as third operator *Oⱼ*.

4. The designing method of any one of claims 1 to 3, wherein the third score of each operator of the predetermined set of operator is a convex combination of the first and the second score of the operator.

5. The designing method of claim 4, wherein the third score Score₃(*O*) of an operator *O* of the predetermined set of operators is given by the formula: ${Score}_{3} \left(O\right) = \frac{c ⋅ {Score}_{1} \left(O\right) + c ′ ⋅ {Score}_{2} \left(O\right)}{c + c ′}$ where:
- *c* and *c*' are numerical coefficients,
- Score₁(*O*) is the first score of the operator*O*, and
- Score₂(*O*) is the second score of the operator*O*.

6. The designing method of any one of claims 1 to 5, wherein the designing method further comprises, after the selecting, by the user, of an operator among the at least one operator of the prediction, increasing by a predetermined number the weight of a respective tuple of the dataset for which:
- the first operator of the respective tuple is the respective operator represented by the block node of the selected output connector,
- the second operator of the respective tuple is the respective operator represented by the antecedent block node of the block node of the selected output connector,
- the third operator of the respective tuple is the selected operator, and
- the object type of the respective tuple is the object type of the selected output connector.

7. The designing method of any one of claims 1 to 6, wherein the input data of the machine-learning function further comprise a value depending on an object cardinality of the selected output connector.

8. The designing method of claim 7, wherein the value depending on the object cardinality of the selected output connector is a binary value indicative of whether the cardinality is 1 or higher than 1.

9. The designing method of any one of claims 1 to 8, wherein the machine-learning function is a multilayer perceptron.

10. A computer program comprising instructions which, when executed by a processor, cause the processor to perform the designing method according to any one of claims 1 to 9.

11. A computer-readable storage medium having recorded thereon the computer program of claim 10.

12. A system comprising a processor coupled to a memory, the memory having recorded thereon the computer program of claim 10.
